(19) Europäisches Patentamt
European Patent Office
Office européen des brevets

(11) **EP 3 789 826 A1**

(12) **EUROPEAN PATENT APPLICATION**

(43) Date of publication:
**10.03.2021 Bulletin 2021/10**

(51) Int Cl.:
**G03F 7/20** (2006.01)     **H01L 21/02** (2006.01)

(21) Application number: **19195527.7**

(22) Date of filing: **05.09.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **KOOIMAN, Marleen**
  **5500 AH Veldhoven (NL)**

• **PISARENCO, Maxim**
  **5500 AH Veldhoven (NL)**
• **SLACHTER, Abraham**
  **5500 AH Veldhoven (NL)**
• **MASLOW, Mark, John**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD FOR DETERMINING DEFECTIVENESS OF PATTERN BASED ON AFTER DEVELOPMENT IMAGE**

(57)      Described herein is a method of training a model configured to predict whether a feature associated with an imaged substrate will be defective after etching of the imaged substrate and determining etch conditions based on the trained model. The method includes obtaining, via a metrology tool, (i) an after development image of the imaged substrate at a given location, the after development image including a plurality of features, and (ii) an after etch image of the imaged substrate at the given location; and training, using the after development image and the after etch image, the model configured to determine defectiveness of a given feature of the plurality of features in the after development image. In an embodiment, the determining of defectiveness is based on comparing the given feature in the after development image with a corresponding etch feature in the after etch image.

FIG. 5

**Description**

<u>FIELD</u>

The present disclosure relates to techniques of improving determination of a defective pattern to further improve a device manufacturing process. The techniques may be used in connection with a lithographic apparatus.

<u>BACKGROUND</u>

Manufacturing semiconductor devices typically involves processing a substrate (e.g., a semiconductor wafer) using a number of fabrication processes to form various features and multiple layers of the semiconductor device. Such layers and features are typically manufactured and processed using, e.g., deposition, lithography, etch, chemical-mechanical polishing, and ion implantation. Multiple devices may be fabricated on different locations on a substrate and then separated into individual devices. This device manufacturing process may be considered a patterning process. A patterning process can include a patterning step to transfer a pattern from a patterning device to the substrate. Also, there can then be one or more related pattern processing steps, such as resist development by a development apparatus, baking of the substrate using a bake tool, etching the pattern onto the substrate using an etch apparatus, measurement/inspection of the transferred circuit pattern, etc. After exposure, the substrate may be subjected to other procedures, such as a post-exposure bake (PEB), development, a hard bake and measurement/inspection of the transferred circuit pattern. This array of procedures is used as a basis to make an individual layer of a device, e.g., an IC. The substrate may then undergo various processes such as etching, ion-implantation (doping), metallization, oxidation, chemo-mechanical polishing, etc., all intended to finish off the individual layer of the device. If several layers are required in the device, then the whole procedure, or a variant thereof, is repeated for each layer. Eventually, a device will be present in each target portion on the substrate.

<u>SUMMARY</u>

In an embodiment, there is provided a method of training a model configured to predict whether a feature associated with an imaged substrate will be defective after etching of the imaged substrate. The method includes obtaining, via a metrology tool, (i) an after development image of the imaged substrate at a given location, the after development image including a plurality of features, and (ii) an after etch image of the imaged substrate at the given location, the after etch image including etched features corresponding to the plurality of features; and training, using the after development image and the after etch image, the model configured to determine defectiveness of a given feature of the plurality of features in the after development image. In an embodiment, the determining of defectiveness is based on comparing the given feature in the after development image with a corresponding etch feature in the after etch image.

Furthermore, there is provided a method for determining etch conditions for an imaged substrate. The method includes obtaining an after development image of the imaged substrate, and initial etch conditions to be used for etching the imaged substrate; determining, via a trained model using the after development image and the initial etch conditions, a failure rate of a feature associated with the imaged substrate, the failure rate being indicative of the feature being defective after etching of the imaged substrate; and modifying, based on the failure rate, the initial etch conditions such that chances of the feature being defective after etching is reduced.

Furthermore, there is provided a method of determining etch characteristic associated with an etch process. The method includes obtaining, via a metrology tool, (i) an after development image (ADI) of an imaged pattern at a given location of a substrate, the imaged pattern includes at least one feature of interest and neighboring features adjacent to the at least one feature of interest, and (ii) an after etch image (AEI) of the imaged pattern at the given location of the substrate, the AEI includes an etched feature corresponding to the at least one feature of interest in the ADI; and determining, using the ADI and the AEI, a correlation between the etched feature and the neighboring features associated with the at least one feature of interest in the ADI, the correlation characterizes the etch characteristic associated with the etching process.

Furthermore, there is provided a method of determining etch conditions associated with an etch process. The method includes obtaining a correlation between an etched feature of interest in an after etched image (AEI) and neighboring features associated with the etched feature of interest in an after development image (ADI); and determining, based on the correlation, etch conditions associated with the etch process so that the correlation remains within a target range.

Furthermore, in an embodiment, there is provided a computer program product comprising a non-transitory computer readable medium having instructions recorded thereon, the instructions when executed by a computer system implementing the aforementioned methods.

<u>BRIEF DESCRIPTION OF THE DRAWINGS</u>

Embodiments will now be described, by way of example only, with reference to the accompanying drawings in which:

Figure 1 shows a block diagram of various subsystems of a lithography system, according to an embodiment;

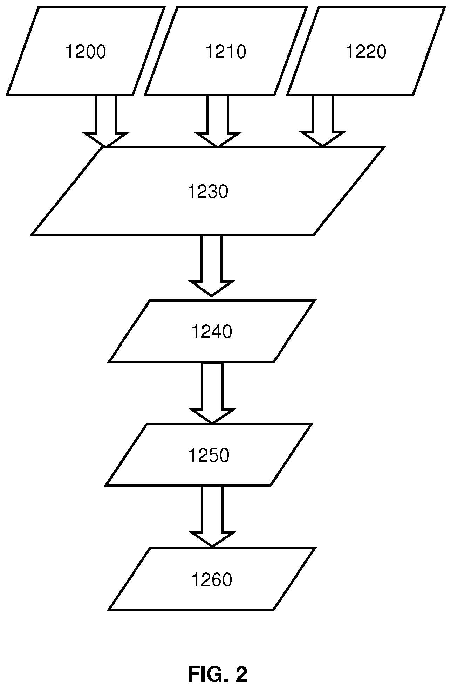

Figure 2 depicts an example flow chart for modeling and/or simulating at least part of a patterning process, according to an embodiment;

Figure 3 illustrates an after SEM damage of a substrate, according to an embodiment;

Figures 4A and 4B is a flow chart of a method for training a model configured to predict whether a feature associated with an imaged substrate will be defective after etching of the imaged substrate, according to an embodiment;

Figure 5 shows an example of determination of defective feature of a substrate based on comparison between ADI and AEI.

Figure 6 illustrates an example of a machine learning model having multiple layers used for training according to the method in Figure 4A, according to an embodiment;

Figures 7A and 7B are examples of ADI and AEI showing defective and non-defective contact holes, according to an embodiment;

Figure 7C is an example CD distribution associated with defectiveness of a feature, according to an embodiment;

Figure 8 is a flow chart of a method for determining etch conditions for an imaged substrate based on a failure rate associated with an imaged pattern.

Figure 9 is a flow chart of a method of determining etch characteristic associated with an etch process, according to an embodiment;

Figure 10 illustrates example ADI including a feature of interest and neighboring features, and an AEI image including an etched feature of interest, according to an embodiment;

Figure 11A shows an example correlation ADI and AEI based on a physical characteristic (e.g., CD) of a feature of interest, according to an embodiment;

Figure 11B shows an example relationship (e.g., based on CD) between neighboring features around a feature of interest in ADI and an etched feature of interest in AEI for a given dose-focus matrix, according to an embodiment;

Figure 12 is a flow chart of a method for determining etch conditions based on a correlation (e.g., determined using method of Figure 9), according to an embodiment;

Figure 13 schematically depicts an embodiment of a scanning electron microscope (SEM), according to an embodiment;

Figure 14 schematically depicts an embodiment of an electron beam inspection apparatus, according to an embodiment;

15 is a block diagram of an example computer system, according to an embodiment;

Figure 16 is a schematic diagram of a lithographic projection apparatus, according to an embodiment;

Figure 17 is a schematic diagram of an extreme ultraviolet (EUV) lithographic projection apparatus, according to an embodiment;

Figure 18 is a more detailed view of the apparatus in Figure 17, according to an embodiment; and

Figure 19 is a more detailed view of the source collector module of the apparatus of Figure 17 and Figure 18, according to an embodiment.

DETAILED DESCRIPTION

Computing power of electronic devices has followed a pattern of increased power and reduced physical size over the years. This has been achieved by increasing the number of circuit components (transistors, capacitors, diodes, etc.) on each integrated circuit (IC) chip. For example, an IC chip in a smart phone, can be as small as a person's thumbnail, and may include over 2 billion transistors, the size of each transistor being less than 1/1000th the size of a human hair. Making an IC is a complex and time-consuming process, with circuit components in different layers and including hundreds of individual steps. Errors in even one step have the potential to result in problems with the final IC. Even one "killer defect" can cause device failure. The goal of the manufacturing process is to improve the overall yield of the process. For example, for a 50-step process to get to a 75% yield, each individual step must have a yield greater than 99.4%, and if the individual step yield is 95%, the overall process yield drops to 7%.

A corresponding difficulty that is in conflict with high yield is the goal of maintaining a fast production schedule (known as throughput, or the number of wafers processed per hour, for example). High process yield and high wafer throughput can be impacted by the presence of defects, especially if operator intervention is required for reviewing the defects. Thus, high throughput detection and identification of tiny defects by inspection tools (such as an optical or electron microscope (SEM)) is essential for maintaining high yield and low cost.

Because the microscopes used for defect detection can only see a small part of the wafer at a time, defect detection can be very time consuming, reducing overall throughput. For example, if every location on a wafer had to be inspected to find defects, wafer throughput could be significantly reduced, as the time it would take to inspect every location on every IC on a wafer would be very long. One approach to this problem is to make use of techniques that predict a defect location based on information obtained from a photolithography system, which is a system used in the manufacture of IC chips. In an example, defect inspection may be performed after imaging or post-process such as after etch. In an example, rather than inspecting every location on a wafer after etch to find defects, prediction may be made of possible defects based on after development process. Advantages of such defect prediction are the etching conditions may be adjusted, or a significantly reduced number of locations may be inspected thereby a corresponding reduction in inspection time and increase in wafer throughput. In another example, a correlation between, e.g., after development and after etch may be established, so that etching process can be controlled based on such correlation. An advantage of such correlation-based process control will effectively be used to reduce defects after etching thereby improving the yield of the patterning process.

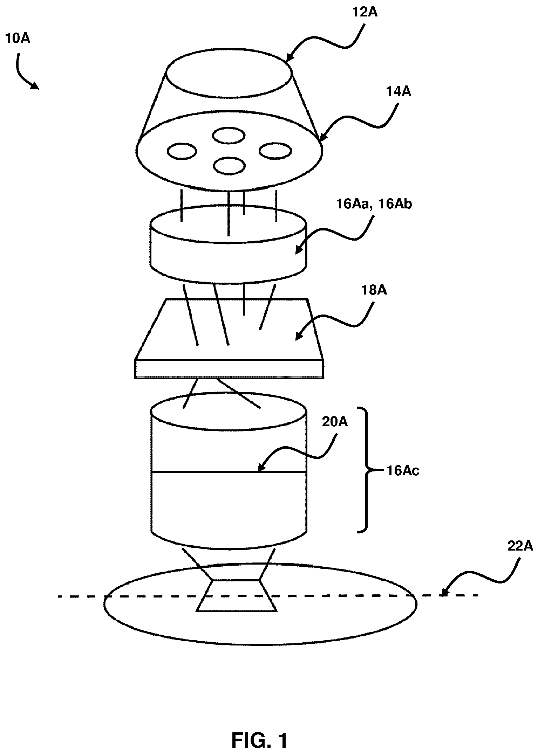

Figure 1 illustrates an exemplary lithographic projection apparatus 10A. Major components are a radiation source 12A, which may be a deep-ultraviolet excimer laser source or other type of source including an extreme ultra violet (EUV) source (as discussed above, the lithographic projection apparatus itself need not have the radiation source), illumination optics which, e.g., define the partial coherence (denoted as sigma) and which may include optics 14A, 16Aa and 16Ab that shape radiation from the source 12A; a patterning device 18A; and transmission optics 16Ac that project an image of the patterning device pattern onto a substrate plane 22A. An adjustable filter or aperture 20A at the pupil plane of the projection optics may restrict the range of beam angles that impinge on the substrate plane 22A, where the largest possible angle defines the numerical aperture of the projection optics NA= n sin($\Theta$max), wherein n is the refractive index of the media between the substrate and the last element of the projection optics, and $\Theta$max is the largest angle of the beam exiting from the projection optics that can still impinge on the substrate plane 22A.

In a lithographic projection apparatus, a source provides illumination (i.e. radiation) to a patterning device and projection optics direct and shape the illumination, via the patterning device, onto a substrate. The projection optics may include at least some of the components 14A, 16Aa, 16Ab and 16Ac. An aerial image (AI) is the radiation intensity distribution at substrate level. A resist layer on the substrate is exposed and the aerial image is transferred to the resist layer as a latent "resist image" (RI) therein. The resist image (RI) can be defined as a spatial distribution of solubility of the resist in the resist layer. A resist model can be used to calculate the resist image from the aerial image, an example of which can be found in U.S. Patent Application Publication No. US 2009-0157360, the disclosure of which is hereby incorporated by reference in its entirety. The resist model is related only to properties of the resist layer (e.g., effects of chemical processes which occur during exposure, PEB and development). Optical properties of the lithographic projection apparatus (e.g., properties of the source, the patterning device and the projection optics) dictate the aerial image. Since the patterning device used in the lithographic projection apparatus can be changed, it may be desirable to separate the optical properties of the patterning device from the optical properties of the rest of the lithographic projection apparatus including at least the source and the projection optics.

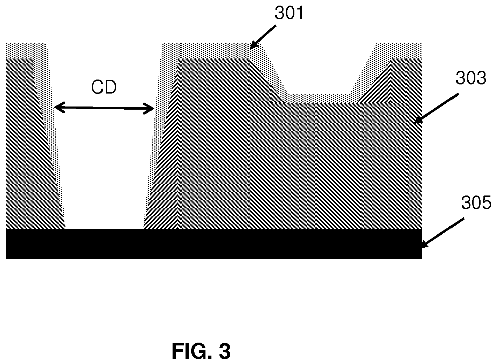

In an embodiment, assist features (sub resolution assist features and/or printable resolution assist features) may be placed into the design layout based on how the design layout optimized according to the methods of the present disclosure. For example, in an embodiment, the methods employ a machine learning based model to determine a patterning device pattern. The machine learning model may be a neural network such as a convolution neural network that can be trained in a certain way (e.g., as discussed in Figure 3) to obtain accurate predictions at a fast rate, thus enabling a full-chip simulation of the patterning process.

A neural network may be trained (i.e., whose parameters are determined) using a set of training data. The training data may comprise or consist of a set of training samples. Each sample may be a pair comprising or consisting of an input object (typically a vector, which may be called a feature vector) and a desired output value (also called the supervisory signal). A training algorithm analyzes the training data and adjusts the behavior of the neural network by adjusting the parameters (e.g., weights of one or more layers) of the neural network based on the training data. The neural network after training can be used for mapping new samples.

In the context of determining a patterning device pattern, the feature vector may include one or more characteristics (e.g., shape, arrangement, size, etc.) of the design layout comprised or formed by the patterning device, one or more characteristics (e.g., one or more physical properties such as a dimension, a refractive index, material composition, etc.) of the patterning device, and one or more characteristics (e.g., the wavelength) of the illumination used in the lithographic process. The supervisory signal may include one or more characteristics of the patterning device pattern (e.g., CD, contour, etc. of the patterning device pattern).

Given a set of N training samples of the form $\{(x_1,y_1), (x_2,y_2),...,(x_N,y_N)\}$ such that $x_i$ is the feature vector of the i-th example and $y_i$ is its supervisory signal, a training algorithm seeks a neural network $g: X \to Y$, where X is the input space and Y is the output space. A feature vector is an n-dimensional vector of numerical features that represent some object. The vector space associated with these vectors is often called the feature space. It is sometimes convenient to represent g using a scoring function $f: X \times Y \to \mathbb{R}$ such that g is defined as returning the y value that gives the highest score:

$$g(x) = \arg\max_y f(x, y).$$

Let F denote the space of scoring functions.

The neural network may be probabilistic where g takes the form of a conditional probability model g(x) = P(y|x), or f takes the form of a joint probability model f(x, y) = P(x, y).

There are two basic approaches to choosing f or g: empirical risk minimization and structural risk minimization. Empirical risk minimization seeks the neural network that best fits the training data. Structural risk minimization includes a penalty function that controls the bias/variance tradeoff. For example, in an embodiment, the penalty function may be based on a cost function, which may be a squared error, number of defects, EPE, etc. The functions (or weights within the function) may be modified so that the variance is reduced or minimized.

In both cases, it is assumed that the training set comprises or consists of one or more samples of independent and identically distributed pairs $(x_i, y_i)$. In an embodiment, in order to measure how well a function fits the training data, a loss function $L: Y \times Y \rightarrow \mathbb{R}^{\geq 0}$ is defined. For training sample $(x_i, y_i)$, the loss of predicting the value $\hat{y}$ is $L(y_i, \hat{y})$.

The risk $R(g)$ of function $g$ is defined as the expected loss of $g$. This can be estimated from the training data as

$$R_{emp}(g) = \frac{1}{N} \sum_i L(y_i, g(x_i)).$$

In an embodiment, machine learning models of the patterning process can be trained to predict, for example, contours, patterns, CDs for a mask pattern, and/or contours, CDs, edge placement (e.g., edge placement error), etc. in the resist and/or etched image on a wafer. An objective of the training is to enable accurate prediction of, for example, contours, aerial image intensity slope, and/or CD, etc. of the printed pattern on a wafer. The intended design (e.g., a wafer target layout to be printed on a wafer) is generally defined as a pre-OPC design layout which can be provided in a standardized digital file format such as GDSII or OASIS or other file format.

An exemplary flow chart for modelling and/or simulating parts of a patterning process is illustrated in Figure 22. As will be appreciated, the models may represent a different patterning process and need not comprise all the models described below. A source model 1200 represents optical characteristics (including radiation intensity distribution, bandwidth and/or phase distribution) of the illumination of a patterning device. The source model 1200 can represent the optical characteristics of the illumination that include, but not limited to, numerical aperture settings, illumination sigma ($\sigma$) settings as well as any particular illumination shape (e.g. off-axis radiation shape such as annular, quadrupole, dipole, etc.), where $\sigma$ (or sigma) is outer radial extent of the illuminator.

A projection optics model 1210 represents optical characteristics (including changes to the radiation intensity distribution and/or the phase distribution caused by the projection optics) of the projection optics. The projection optics model 1210 can represent the optical characteristics of the projection optics, including aberration, distortion, one or more refractive indexes, one or more physical sizes, one or more physical dimensions, etc.

The patterning device / design layout model module 1220 captures how the design features are laid out in the pattern of the patterning device and may include a representation of detailed physical properties of the patterning device, as described, for example, in U.S. Patent No. 7,587,704, which is incorporated by reference in its entirety. In an embodiment, the patterning device / design layout model module 1220 represents optical characteristics (including changes to the radiation intensity distribution and/or the phase distribution caused by a given design layout) of a design layout (e.g., a device design layout corresponding to a feature of an integrated circuit, a memory, an electronic device, etc.), which is the representation of an arrangement of features on or formed by the patterning device. Since the patterning device used in the lithographic projection apparatus can be changed, it is desirable to separate the optical properties of the patterning device from the optical properties of the rest of the lithographic projection apparatus including at least the illumination and the projection optics. The objective of the simulation is often to accurately predict, for example, edge placements and CDs, which can then be compared against the device design. The device design is generally defined as the pre-OPC patterning device layout, and will be provided in a standardized digital file format such as GDSII or OASIS.

An aerial image 1230 can be simulated from the source model 1200, the projection optics model 1210 and the patterning device / design layout model 1220. An aerial image (AI) is the radiation intensity distribution at substrate level. Optical properties of the lithographic projection apparatus (e.g., properties of the illumination, the patterning device and the projection optics) dictate the aerial image.

A resist layer on a substrate is exposed by the aerial image and the aerial image is transferred to the resist layer as a latent "resist image" (RI) therein. The resist image (RI) can be defined as a spatial distribution of solubility of the resist in the resist layer. A resist image 1250 can be simulated from the aerial image 1230 using a resist model 1240. The resist model can be used to calculate the resist image from the aerial image, an example of which can be found in U.S. Patent Application Publication No. US 2009-0157360, the disclosure of which is hereby incorporated by reference in its entirety. The resist model typically describes the effects of chemical processes which occur during resist exposure, post exposure bake (PEB) and development, in order to predict, for example, contours of resist features formed on the substrate and so it typically related only to such properties of the resist layer (e.g., effects of chemical processes which occur during exposure, post-exposure bake and development). In an embodiment, the optical properties of the resist layer, e.g., refractive index, film thickness, propagation and polarization effects- may be captured as part of the projection optics model 1210.

So, in general, the connection between the optical and the resist model is a simulated aerial image intensity within the resist layer, which arises from the projection of radiation onto the substrate, refraction at the resist interface and multiple reflections in the resist film stack. The radiation intensity distribution (aerial image intensity) is turned into a latent "resist image" by absorption of incident energy, which is further modified by diffusion processes and various loading effects. Efficient simulation methods that are fast enough for full-chip applications approximate the realistic 3-dimensional intensity distribution in the resist stack by a 2-dimensional aerial (and resist) image.

In an embodiment, the resist image can be used an input to a post-pattern transfer process model module 1260. The post-pattern transfer process model 1260 defines performance of one or more post-resist development processes (e.g., etch, development, etc.).

Simulation of the patterning process can, for example, predict contours, CDs, edge placement (e.g., edge placement error), etc. in the resist and/or etched image. Thus, the objective of the simulation is to accurately predict, for example, edge placement, and/or aerial image intensity slope, and/or CD, etc. of the printed pattern. These values can be compared against an intended design to, e.g., correct the patterning process, identify where a defect is predicted to occur, etc. The intended design is generally defined as a pre-OPC design layout which can be provided in a standardized digital file format such as GDSII or OASIS or other file format.

Thus, the model formulation describes most, if not all, of the known physics and chemistry of the overall process, and each of the model parameters desirably corresponds to a distinct physical or chemical effect. The model formulation thus sets an upper bound on how well the model can be used to simulate the overall manufacturing process.

In patterning processes, like photolithography, electron beam lithography, directed self-assembly, etc., an energy sensitive material (e.g., photoresist) deposited on the substrate typically undergoes a pattern transfer step (e.g., via light exposure). Following the pattern transfer step, various post steps such as resist baking, and subtractive processes such as resist development, etches, etc., are applied. These post-exposure steps or processes exert various effects on the substrate that cause the patterned layer or etches to have structures having dimensions different from targeted dimensions.

Computational analysis of the patterning processes employ a prediction model that, when properly calibrated, can produce accurate prediction of dimensions output from the patterning processes. A model of post-exposure processes is typically calibrated based on empirical measurements. The calibration process includes running a test wafer with different process parameters, measuring resulting critical dimensions after post-exposure processes, and calibrating the model to the measured results. In practice, well calibrated models, making fast and make accurate predictions of dimensions, serve to improve device performance or yield, enhance process windows or increase design choices. In an example, use of deep convolutional neural networks (CNNs) for modeling post-exposure processes yields model accuracy comparable or superior to that produced with traditional techniques, which often involve modeling with physical term expressions or closed form equations. Compared to the traditional modelling techniques, deep learning convolutional neural networks alleviate the demand of knowledge of process in order for model development, and lifts dependence on an engineer's personal experience on model tuning. Briefly, a deep CNN model for post-exposure processes consists of an input and an output layer, as well as multiple hidden layers, such as convolutional layers, normalization layers, and pooling layers. The parameters of the hidden layers are optimized to give a minimum value of a loss function. In embodiment, CNN models may be trained to model the behavior of any process, or a combination of processes related to the patterning process.

Random, stochastic failures of structures (also referred as features) on a substrate are considered a undesirable in lithography printing (e.g., EUV lithography). Failures of the structures can be identified either after lithographic imaging of the structures on the substrate, or after etching of the imaged substrate on the substrate. Benefits of identifying and classifying failures after etch is that it is easier to interpret images of the substrate as it provides a direct correlation to a performance (e.g., yield) of the patterning process. However, identifying failures after the lithographic step is a more direct measurement of the lithographic performance.

There is a number of algorithms that classify failures of structures (e.g., contact holes) after development in SEM pictures. For example, Fractilia software measures what is on the substrate not what is on the SEM image. In another example, Stochalis software analyzes CD-SEM images based on brightness of pixels. CD-SEM refer to Critical Dimension Scanning Electron Microscope, which is a dedicated system for measuring the dimensions of the fine patterns formed on a semiconductor substrate. However, criteria for defect classification do not depend on etch conditions used during etching, rather are based on common sense based interpreting of SEM images. For example, error criteria may be SEM contrast or critical dimension (CD) after development of an imaged substrate.

Apart from that, CD may be measured using after development image (ADI) or after etch image (AEI) with the CD-SEM, and a transfer of the CD can be measured. However, an ADI SEM measurement damages the resist, which affects the CD after etch. Therefore, the CD based on ADI and AEI are measured at a different location, and only an average CD, Local CD Uniformity (LCDU, a standard deviation of CD) or a CD distribution may be compared.

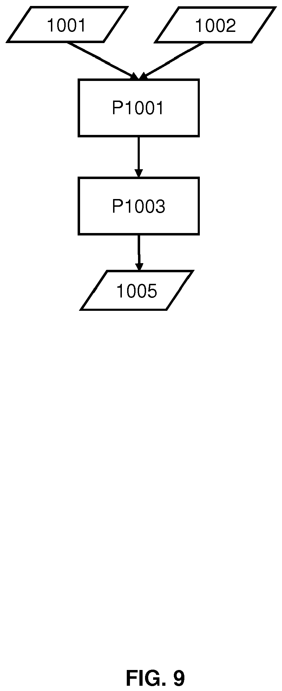

The disadvantages of the current failure (or defect) classification after lithography is that the defect classification does not depend on the process conditions or the etch conditions, while a final defect (or failure) rate associated with the substrate does depend on such conditions. The defect classification is calibrated based on either the capture rate of programmed defects or by comparing defect rates before and after etch. However, it has been shown that programmed defects are statistically different from random defects see publication P. De Bisschop, E. Hendrickx, "Stochastic effects in EUV lithography," Proc. SPIE 10583, Extreme Ultraviolet (EUV) Lithography IX, 105831K (19 March 2018); doi: 10.1117/12.2300541. Therefore, a good capture rate of programmed defects does not guarantee an accurate result. Furthermore, it has been reported that the defect rate before and after etch do not generally match. For example, the reference P. De Bisschop & E. Hendrickx, "Stochastic effects in EUV lithography," SPIE 2018 shows in figure 9 that the ADI and AEI failure rates can be a factor 0.1 to 1000 different.

As mentioned earlier and now referring to Figure 3, an after-litho SEM metrology damages a resist layer 301/303 e.g., placed on an oxide layer 305. For example, the resist layer 301 before SEM measurement shrinks to the layer 303 after SEM measurement. In another case, carbon can be redeposited due to illumination with the SEM on the resist 301. Thus, measuring SEM twice at the same location may affect the CD as measured by the SEM after lithographic step and after etch step.

In an embodiment, missing contact hole defects after etch are caused by a layer of remaining resist inside the contact hole. However, in the present application it was realized that the resist shrinks during SEM, but that the SEM electrons cannot completely remove a remaining layer of resist in a contact hole, see **Error! Reference source not found.**3. Also, it is realized that the carbon redeposition does not fill the full hole such that it closes. Hence, such finding is contrary to conventional belief. Thus, SEM damage may affect the CD but not a failure rate of the structures associated with a pattern. As such, the method of present embodiment enables determination of failure rates more accurately, where the determination is based on one-to-one feature comparison between ADI and AEI rather than using an average CD based determination of failure rate.

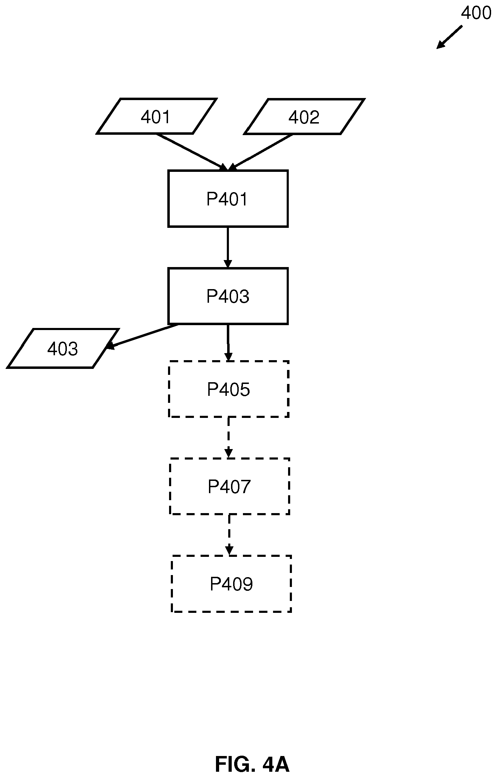

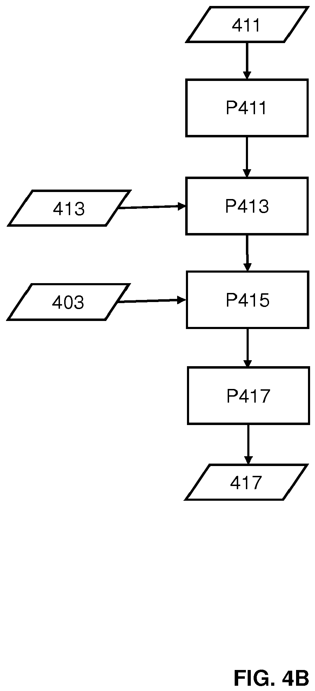

Figures 4A and 4B is a flow chart of a method for training a model configured to predict whether a feature associated with an imaged substrate will be defective after etching of the imaged substrate.

Procedure P401 involves obtaining, via a metrology tool, (i) an after development image 401 of the imaged substrate at a given location, the after development image including a plurality of features, and (ii) an after etch image 402 of the imaged substrate at the given location, the after etch image including etched features corresponding to the plurality of features.

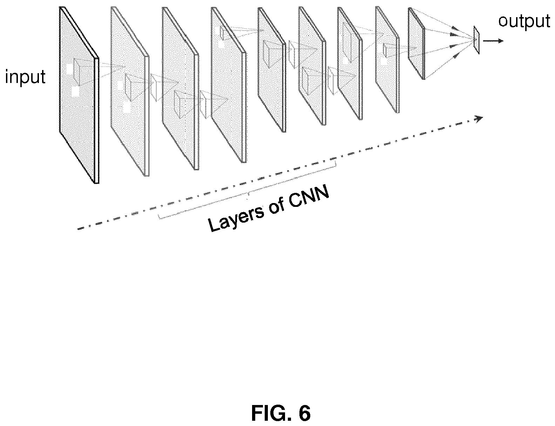

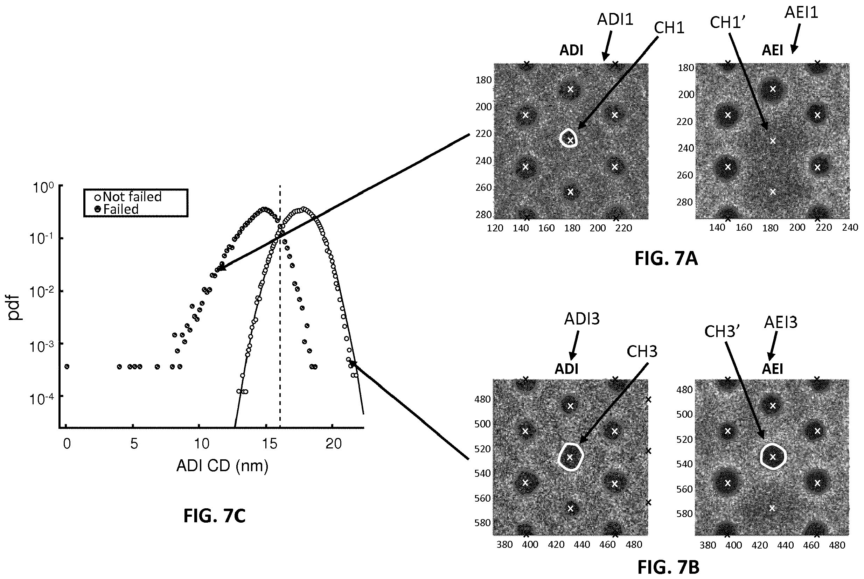

In an embodiment, the model is an empirical model or a machine learning model. In an embodiment, the empirical model is a function of a physical characteristic of the feature associated with the imaged substrate (e.g., after development). An example of training based on empirical model is illustrates in Figure 7A-7C where a physical characteristic such as CD of the feature after development process is used as a model variable. In an embodiment, the model is trained to identify a CD threshold (e.g., 16 nm) that can classify more than 90% of the potentially defective features, based on ADI, correctly. In other words, features classified as defective in ADI will have high likelihood of failure after etch compared to features that were not classified as defective. In another example, grey scale values of the ADI are used to define the model. For example training the model to identify a grey scale value threshold that can classify more than 90% of the potentially defective features, based on ADI, correctly. In an embodiment, Figure 6 illustrate training a CNN model. The example training based on CD, grey scale values and CNN model is discussed later in the disclosure.

In an embodiment, the obtaining of the after development image involves imaging, via a patterning apparatus, a mask pattern on a substrate; obtaining a developed substrate (e.g., resist development) of the imaged substrate; aligning the metrology tool (e.g., SEM) to the developed substrate at the given location; and capturing an image of the developed substrate. In an embodiment, the after development image is a pixelated image, where an intensity value of the pixel is indicative of presence or absence of a feature on the substrate. For example, an intensity value of a pixel is a metric for a number of secondary electrons on the substrate. The secondary electrons may depend on: (i) secondary electron yield of a material (e.g., higher yield for resist than for an underlayer on the substrate), and (ii) geometry that shadows the intensity in the hole such that it is darker and gives higher yield at the edges of the hole than at the centre. For example, a white band around the hole may be seen.

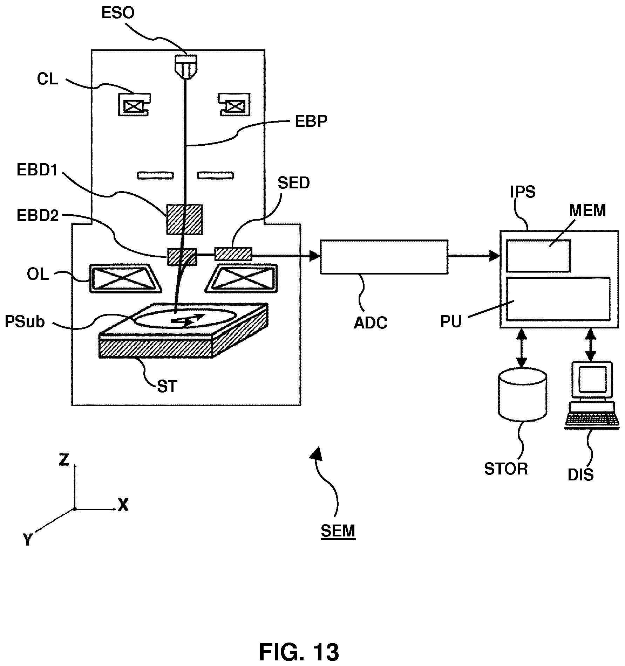

In an embodiment, the metrology tool is a SEM (e.g., Figure 13) and the ADI and the AEI images are SEM images. In an embodiment, the aligning of the SEM with imaged or after etch substrate is based on addressing features outside FOV of SEM. For example, the SEM may be configured to have a built-in option to align on addressing features, where the addressing features are associated with locations at which scanning should be performed. In another example, a unit cell of a pattern is larger than an uncertainty of the SEM positioning system (e.g. for a logic device), so alignment may also be based on the features that are in the image, such that the pattern itself is used as a location mark. In an embodiment, for alignment purposes, including extra location mark inside the FOV of the SEM is undesired as it affects the lithographic image, which makes the features around it non-representative. In addition, it is not desired to adjust the mask pattern in a functional area of the substrate for metrology.

In an embodiment, the obtaining of the after etched image involves etching, via an etch process with specified etch conditions, the imaged substrate; aligning the metrology tool to the etched substrate at the given location; and capturing the after etched image of the etched substrate. In an embodiment, the etch conditions include etchant composition, plasma gas parameters, etching rate, electro-magnetic fields, a plasma potential, an inductive or a capacitive type of etching, a temperature of the substrate, ion energy distribution, ion angular distribution, sputtering and redeposition rates, or a combination thereof.

In an embodiment, the alignment is never perfect, so a correlation between ADI and AEI images is used to make sure that the alignment was correct. However, one problem is that an addressing feature used for alignment gets damaged or shifted due to the etching process, which affects the addressing. Hence, according to present embodiment, the AEI image is digitally shifted over a discrete number of pitches in all symmetry directions with respect to the ADI image, and check for which one the correlation between ADI and AEI CD is maximum. In an embodiment, there is a clear maximum due to a small shift (e.g., shift by 1 or 2 pitches).

Procedure P403 involves training, using the after development image 401 and the after etch image 402, the model configured to determine defectiveness of a given feature of the plurality of features in the after development image, where the determining of defectiveness is based on comparing the given feature in the after development image with a corresponding etch feature in the after etch image. In an embodiment, the defectiveness is characterized by at least one of: a binary determination of defective or not defective; or a probability of the given feature being defective.

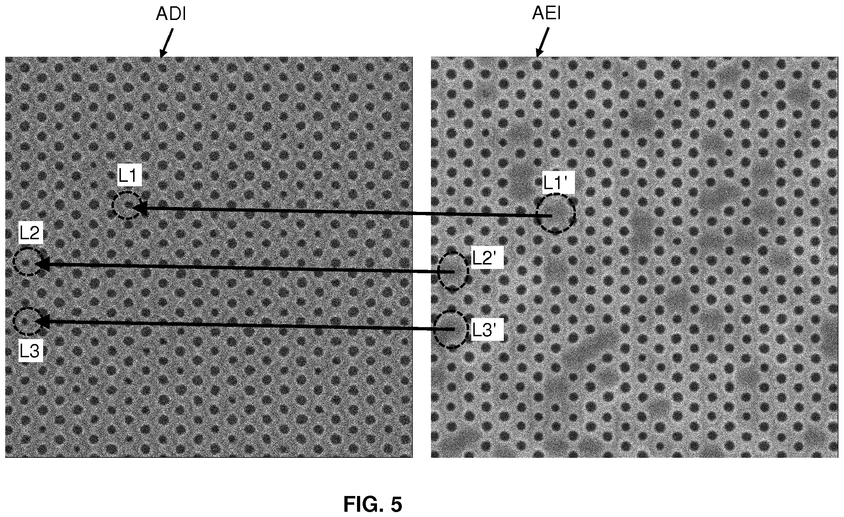

In an embodiment, the training involves aligning, based on the plurality of features, the after development image and the after etch image; comparing (e.g., shown in Figure 5) each of the features of the plurality of features in the after development image with the corresponding features in the after etch image; determining, based on the comparison, whether a given etched feature in the after etch image satisfy a defect condition; responsive to not satisfying the defect condition, classifying the identified feature as defective; and adjusting model parameter values of the model based on the defectiveness of the identified feature. In an embodiment, the defect condition refers to a desired limit associated with a physical characteristic of the structure, where if the limit is not satisfied the structure is considered defective.

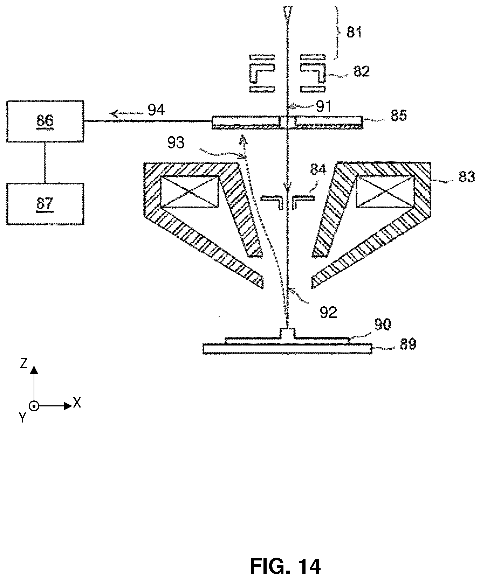

Referring to Figure 5, an example of determination of defective feature of a substrate based on comparison between ADI and AEI is shown. In an embodiment, the ADI and AEI are obtained, via a metrology tool (e.g., SEM in Figure 13 or inspection tool in Figure 14). The ADI is an after development image of the substrate obtained after imaging (e.g., pattern transfer step), via a patterning apparatus (e.g., lithographic apparatus) the substrate and further performing a development process post imaging. The example ADI includes an array of contact holes, for example, holes at locations L1, L2, and L3. The AEI is an after etch image comprising array of holes corresponding to the contact holes of the ADI. In the present example, comparing of the holes in the AEI and the ADI shows missing holes in the AEI. For example, the ADI includes holes (present without any defects) at locations L1, L2, and L3. However, after etching process, the AEI image shows missing holes at locations L1', L2' and L3' corresponding to locations L1-L3, respectively, thereby indicating failure of contact holes. In other words, holes at L1-L3 in ADI have chances of being defective after etching the substrate. Hence, the holes in ADI at locations L1, L2, L3 are classified as defective.

Thus, present disclosure compares holes at one location of the substrate after development with holes at the same location of the substrate after etch. In contrast, the existing technology compares holes at different locations on the substrate after development step and after etch step thereby preventing a one-to-one comparison of features. Thereby, the present disclosure generates more accurate data related to defects associated with structures of the substrate. Hence, a model trained based on such data can predict defective features more accurately and appropriate adjustments to patterning process (e.g., an etch process) may be performed to improve the yield of the patterning process. In an embodiment, the adjustments may involve changing the focus or dose of the lithographic apparatus, or adjusting the chemical composition of the resist.

In an embodiment, the model may be an empirical model trained based on a defective condition. In an embodiment, the defective condition is at least one of: grey scale values in an enclosed contour within the after etch image; and a physical characteristic of the given etched feature in the after etch image. In an embodiment, wherein the physical characteristic is at least one of: a critical dimension of the given etched feature; or a displacement of the given etched feature with respect to the given feature of the after development image.

Figure 7A-7C illustrates example of CD-based defect classification. In an embodiment, the empirical model is based on CD-thresholding, where the CD threshold determines whether a feature may be defective. Figure 7C shows CD distribution of contact holes in ADI and corresponding contact holes AEI that may be defective (e.g., failure prone or not). The distribution shows CD values of the contact holes in ADI, CD values of contact holes not failed after etching, and CD values of failed holes after etch. In Figure 7A, comparing ADI1 and AEI1 shows hole CH1 is classified as failed which is accurate as CH1' is missing in AEI1. Further, in Figure 7B, comparing ADI3 and AEI3 shows hole CH3 is classified as not failed which is also correct as CH3' is not missing in AEI3.

In an embodiment, failing holes (e.g., missing in AEI) are generally smaller in size relative to desired size. For classification, a CD threshold may be employed on the ADI, where contact holes breaching are classified as potential defect in AEI. For example, a CD threshold Th1 is approximately 16 nm, so holes smaller than Th1 (e.g., 16 nm) can be classified as defective. In an embodiment, 91.3% holes were classified correctly.

In an embodiment, the model is a machine learning model such as a convolution neural network. Then, the model parameters are weights and/or bias associated with one or more layers of the machine learning model (e.g., CNN).

Figure 6 illustrates an example CNN trained using ADI and AEI data (e.g., ADI and AEI images of Figure 5) as input. Based on the input, a defect classification of the features may be based on the comparison between ADI and AEI as discussed herein. Then, the defect classification can be an output of the CNN. In an embodiment, ADI and AEI may be feature vectors provided to the CNN.

In an embodiment, the trained model (e.g., CNN (e.g., Figure 5), a CD-based threshold model (e.g., discussed in Figure 7) is further configured to predict a failure rate associated with the given pattern of the after development image, the failure rate being indicative of a defect occurrence when the imaged substrate is etched using the specified etch conditions. For example, based on the defect classification of the features and the total number of features, a failure rate associated with the feature after etching may be determined. For example, the failure rate of a feature (e.g., contact holes) is a ratio of a total defective instance of the feature and total number of the features.

In an embodiment, the further configuring of the training model involve following procedures. For example, procedure P405 involves classifying the plurality of patterns associated with a pattern of interest as defective or not defective; procedure P407 involves determining a total number of defective patterns associated with the pattern of interest; and procedure P409 involves computing the failure rate of the pattern of interest as ratio of the total number of defective pattern and a total number of patterns in the plurality of patterns.

In an embodiment, the method 400 may further comprise adjusting an etching conditions. An example implementation involves execution procedures in Figure 4B. Procedure P411 involves imaging, via a patterning apparatus, a desired pattern 411 on a substrate. The imaged substrate may be further developed (e.g., resist development) and post-processed (e.g., etching). Procedure P413 involves obtaining an after development image of the imaged pattern. Furthermore, an initial etch conditions 413 may be obtained. Procedure P415 involves executing the training model 403 using the after development image to classify whether the desired pattern will be defective after etching. Procedure P417 involves adjusting (or determining), based on the classified defective pattern, an etching condition 417 such that imaged pattern will not be defective after etching.

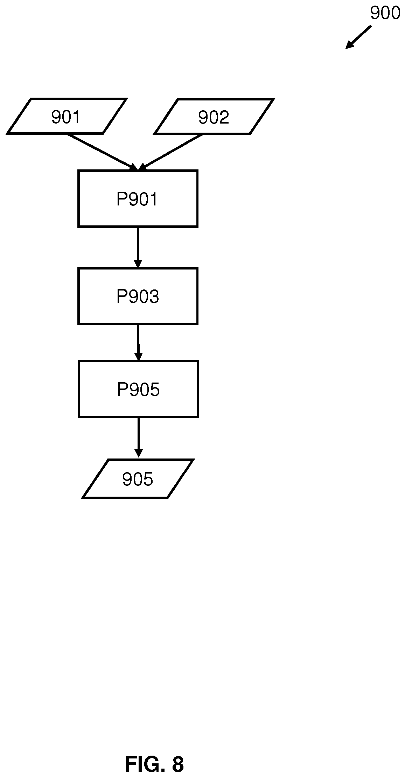

Figure 8 is a flow chart of a method for determining etch conditions for an imaged substrate based on a failure rate associated with an imaged pattern. Procedure P901 involves obtaining an after development image 901 of the imaged substrate, and initial etch conditions 902 to be used for etching the imaged substrate. In an embodiment, the etch conditions comprise at least one of an etchant composition, plasma gas parameters, an etching rate, electro-magnetic fields, a plasma potential, an inductive or a capacitive type of etching, a temperature of the substrate, ion energy distribution, ion angular distribution, sputtering and redeposition rates, or a combination thereof.

Procedure P903 involves determining, via a trained model (e.g., the trained model 403) using the after development image 901 and the initial etch conditions 902, a failure rate of a feature associated with the imaged substrate, the failure rate being indicative of the feature being defective after etching of the imaged substrate. Thus, the trained model provides failure predictions before actual failure that may occur after etching.

Procedure P905 involves modifying, based on the failure rate, the initial etch conditions 902 such that chances of the feature being defective after etching is reduced. The modified etch conditions 905 can be further used to etch the imaged substrate thereby improving the yield (e.g., reduced failure of features/structures on the substrate) of the patterning process.

In an embodiment, the modifying the etch conditions is an iterative process. An iteration involves obtaining a relationship between a given etch condition and a given failure rate associated with a given feature; determining, via executing an etch model using the after development image and the etch conditions, an after etch image associated with the imaged substrate; determining, based on the after etch image, whether the given feature satisfies a defect condition; and responsive to not satisfying the defect condition, identifying, based on the relationship, another etch conditions associated with a lower failure rate compared to the failure rate.

In an embodiment, the defect condition of the feature at least one of: an omission of the feature; a displacement range associated with the feature; or a tolerance range associated with critical dimension of the feature.

In a lithography process, the structures printed in resist on a substrate should be etched into a layer underneath to make a functional chip. The etching process/step can be used to smoothen out local variations in CD of the features, such that the local CD uniformity (LCDU) is reduced after etch. One of the underlying mechanisms by which the etch step reduces the LCDU, is by loading effects.

The effect of loading is relationship between an etch rate and how populated an area on the substrate is with structures. In an embodiment, the effect of loading is that in a densely populated area of the substrate (e.g., a region having high percentage of structures within a defined area compared to other regions on the substrate), the etch rate is lower than in areas that are less populated or relatively more empty (e.g., less area is covered with structures). So if a hole and/or its neighbours have large ADI holes (e.g., because of local fluctuations), for example, 1 nm larger than the average holes, the etch will be slower. The slower etch may cause the AEI holes to be less than 1 nm larger than the average hole AEI. The physical origin of loading effects is shortage of etchant, inhibition of the etch by by-products of the etch, or both.

Three example parameters related to the etch loading are: (i) an extent of the loading effects - that is a distance (e.g., in nm) up to which features impact each other. For example, a value between 40 and 100 nm. In an embodiment, the extent is represented by radius "R" in the equation of the etch rate equation below); (ii) a change in etch bias per change in mean CD of the neighbours in the relevant area. The value of parameter (ii) depends on the mean pattern density. The unit can be nm/nm, and example values, according to present disclosure may be between 0 and 0.75 nm/nm; and (iii) a correlation coefficient between the size of neighbouring holes in ADI and the size of the etched hole in AEI. Example values of the correlation can be between 0 and 0.2.

In an embodiment, the etch loading depends on the pattern density and has various length scales, ranging from a wafer-scale to a portion of wafer or a sub resolution. In an embodiment, the pattern density is a fraction of area occupied by structures in a given area around the structure or feature of interest. In an embodiment, the loading effect may be on a length scale between 40 and 100 nm (e.g., 1 to 2 pitches). However, the present disclosure is not limited by such range. In an embodiment, the loading effect ranging from a sub-resolution (e.g. 10 nm) to an OPC-ambit region (e.g., a region having approximately 300 nm - 1 μm radius) may be optimized during an etch optimization for a specific structure to ensure a desired yield for the resist by tuning a target-CD's and the desired yield during a pattern transfer. Existing etch optimization process is a long and tedious procedure. For example, a manual optimization involves tuning knobs of an etch apparatus so that a desired yield of the die is achieved.

In an embodiment, the loading effect is a type of saturation. Loading effect (also called loading behaviour) may be different for each of the etch cycles. Specific etch techniques cycle between very small differences in loading effects to reduce, for example, line edge roughness (LER) or line width roughness (LWR), or improve local CD uniformity. The loading effect, in addition to balancing the sputter, etch, and redeposition rates, has both a spatial component and an angular component to create preferential etches for features of varying CD/Pitch/Duty cycles in the X or Y orientation, for example. The angular component is governed by an electro-magnetic (EM) field, gas flow design, or both. Once an etch cycle has consumed the preferential material at the spatial frequency and orientation based on the loading effect, the cycle would effectively saturate. Such saturation may be detected by a spectrometer.

In an embodiment, data from an on-board optical spectrometer that can be used to determine a constituency of materials in the plasma as a means for endpoint detection per cycle. This could be used to trigger the next cycle. In an embodiment, data from spectrometer can be supplemented/replaced by data from an on-board laser interferometer that can determine thickness of a material being etched at a specific location/angle on the substrate.

The present disclosure is related to quantification of an etch characteristic such as a short-range etch loading effect or micro loading. Currently, the etch loading is characterized before the etch optimization process by analyzing test structures, and by modeling in (OPC) software suites (e.g., Tachyon, Synopsis, Coventor, etc.). To this end, features with variable pitch and CD are printed and etched, and an etch rate is fitted with an empirical formula that accounts for an open area within a defined region (e.g., circle of particular radius) around a point of interest. For example, the empirical model for etch rate ER may be defined as:

$$ER = ER_{nom} + \tau \cdot OA(R)$$

In the above ER model, *ER* is an etch rate associated with an etching process, $ER_{nom}$ is the nominal etch rate associated with the etching process, $\tau$ is a sensitivity to the pattern density, and *OA(R)* is the open area in a circle with radius *R*. The parameters *R*, $\tau$ and $ER_{nom}$ are fit parameters of the model. In advanced models, multiple radii can be used additively, different convolution-filters applied can be applied, or a directional dependency can be incorporated.

In an embodiment, the etch rate ER may be used to simulated (e.g., using convetor software) an etch bias (e.g., a difference between ADI CD and AEI CD). Further, a relationship between an etch bias, sensitivity to the pattern density, and open area may be modelled. The ADI CD and AEI CD refers to CD of features in ADI and AEI.

In an embodiment, a pattern transfer process may be comprise a combination of an etching and (re-)deposition. An example etching process involves physical sputtering of material and chemical etching. The sputtered material and/or added gas constituents also ensure (re)deposition. In such process, a set sheath voltage influences an ion-angle of the sputtering process and a μ-wave power density of the plasma/sputtering-speed. The sputter-rate of a material is dependent on the incidence angle, ion-velocity and material composition which allows tweaking of profiles. For example, a Fluor gas pressure determines the redeposition during the etching process.

In an etch optimization process, the desired etch loading and redeposition is not tuned based on expected dependencies that are initially simulated, but mostly by physical intuition & experimental testing on sweeps of many different etch-parameters that impact some of the above effects.

However, there are several disadvantages to the existing approaches for estimating the micro-loading effect. For example, measurements are not on product's structures essential for functionality of the chip, rather on test structures. According to present disclosure, micro-loading effects strongly depend on the pattern density, thus characterization of such loading effect on the structure of interest is more appropriate. Another example disadvantage is short-range loading effects depend on a condition in a focus-exposure matrix (FEM). Such dependence cannot yet be quantified by existing methods.

Figure 9 is a flow chart of a method of determining etch characteristic associated with an etch process. In an embodiment, the etch characteristic is associated with uniformity of etching an imaged substrate. For example, an etch characteristic indicates substrate etches faster at the edge and slower at the center. In another example, an etch characteristic indicates micro-loading effect refers to an etch rate that depends on local pattern density. In an embodiment, etch rate refers to an etched depth per unit time, e.g., 100 to 1000 angstroms per minute. The etch rate may be further used to (via simulation using conventor software) determine etch bias (e.g., a difference between ADI CD and AEI CD). For example, an etch loading refers to a difference between etch rate associated with a given feature located in an area of high density compared to the same feature in an area of low density (isolated) on the same chip. An example reason being associated with a local depletion of reactant. In order to compensate for the etching characteristic such as loading effect, pressure, diffusion rate, etchant flux, etc. may be adjusted. The method of Figure 9 is further discussed in detail below.

In an example, measurements (e.g., AEI CD) may be performed half-way the etch process (if you have an iterative etch procedure), or after Sequential Infiltration Synthesis (SIS), a step that can be applied before etch.

Note that after development image and after etch image are used as examples of different processes of a patterning process. However, the present disclosure is not limited to after development and after etch. A person skilled in the art can apply the methods herein to other processes related to the patterning process. For example, a correlation may be established between a first layer (e.g., resist layer) and a subsequent layer on which a different process (e.g., etch) may be performed after processing of the first layer. The principle described herein works with any etch and combination of layers (e.g., a first resist, a second resist layer, etc.) of the substrate being patterned.

Procedure P1001 involves obtaining, via a metrology tool, (i) an after development image (ADI) of an imaged pattern at a given location of a substrate, the imaged pattern includes at least one feature of interest and neighboring features adjacent to the at least one feature of interest, and (ii) an after etch image (AEI) of the imaged pattern at the given location of the substrate, the AEI includes an etched feature corresponding to the at least one feature of interest in the ADI. For example, the imaged pattern may be of an array of contact holes at a center of the substrate. Within the array of the contact holes is the feature of interest may be a contact hole at a particular coordinate (e.g., GDS coordinate).

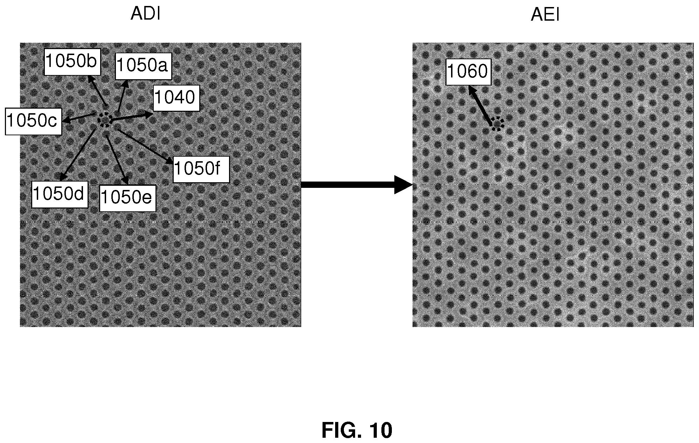

In an embodiment, the at least one feature of interest is at least one of a contact hole; a line; a line end; or a critical features or a portion thereof. In an embodiment, the neighboring features are at least one of: a plurality of contact holes at a defined orientation with respect to the feature of interest (e.g., see Figure 10); or a plurality of lines with a defined pitch. In an example, a neighbour can be a line segment of the same line at a distance from the line segment of interest.

In some embodiment, multiple instances of a feature of interest (or multiple different features) in one image and their neighbors can be used to established a correlation between the feature of interest and corresponding etch feature of interest. In some embodiment, one feature of interest in multiple images (e.g., obtained at different locations such as centre, edge, or other radial distance on a substrate) may be used to establish the correlation coefficient. In another example, from a lithographic apparatus point of view, multiple images at a small distance from each other may be obtained. For example, multiple images at least in the same die. The CD may be a bit different on different wafer locations, and that will then dominate the correlation coefficient. An example distance between images can be 1 um.

Figure 10 illustrates example ADI including a feature of interest 1040 and neighboring features 1050a-1050f and an AEI image including an etched feature of interest 1060 corresponding to the feature of interest 1040, only etched. In other words, both 1040 and 1060 are at the same contact holes at different point (e.g., after image and after etch) in the patterning process. In an embodiment, the neighboring features 1050a-1050f are adjacent to the feature of interest 1040. The neighboring features 1050a-1050f are located at a specified distance from the feature of interest 1040. In an embodiment, the specified distance also affects the etch characteristics. For example, closer the neighboring features to the feature of interest higher the etch loading effect.

In an embodiment, a fraction of area occupied by the neighboring features 1050a-1050f around the feature of interest define a pattern density. The higher the surface area covered by the neighboring features, the greater the pattern density. As mentioned earlier, the pattern density affects etch characteristic (e.g., etch loading effect) of an etch process.

Procedure P1003 involves determining, using the ADI and the AEI, a correlation between the etched feature and the neighboring features associated with the at least one feature of interest in the ADI, the correlation characterizes the etch characteristic associated with the etching process.

In an embodiment, the determining of the correlation involves using multiple ADI images having one feature of interest. Accordingly, the determining of the correlation may involves obtaining (i) a plurality of ADI at a plurality of given locations of the substrate, each ADI having a same feature of interest (e.g., a contact hole having CD of approximately 21nm), and (ii) a plurality of AEI at the plurality of the given locations, each AEI having the etched feature (e.g., an etched contact hole of CD 20nm) of interest corresponding to the feature of interest. In an embodiment, an ADI CD is larger than the AEI CD of the feature of interest, for example, ADI CD may be 21 nm and the AEI CD may be 20 nm. Then, the correlation can be established between the neighboring features of the feature of interest in each ADI and the etched feature of interest in each of the AEI. An example function of correlation using CD is explained below, however, similar function may be established using other physical characteristics (e.g., quantifiable measurements) related to the feature of interest.

In an embodiment, the correlation is a function of the average pattern density of the neighboring features adjacent to the at least one feature of interest. In an embodiment, the correlation between the etched feature and the neighboring features in the ADI depends on at least one of: a geometric shape of the at least one feature of interest or the neighboring features; a geometric shape of assist features or bias associated with the at least one feature of interest; a distance between the at least one feature of interest and the neighboring features; a distance along a line feature; a critical dimension of the at least one feature; coordinates on the substrate associated with the at least one feature of interest, the neighboring features, and the etched feature of interest; assist features or lack of assist features around the at least one feature of interest (e.g., around the feature of interest refers to an end of an array of features including the feature of interest); or a random variation of an edge position from its expected position associated with the at least one feature of interest. In an embodiment, the expected position of an edge (e.g., a feature contour) refers to a GDS location (e.g., in a design layout) or an averaging of similar features.

In an embodiment, the correlation may be computed indirectly based on patterning process parameters such as dose and focus of a scanner, an etch temperature, plasma gas parameters, etchant composition, electro-magnetic fields, plasma potential, inductive or capacitive etching, temperature, ion energy distribution, ion angular distribution, parameters associated with sputtering and redeposition rates. For example, the indirect determining of the correlation involves via tuning or simulating the patterning process by adjusting one or more of the aforementioned patterning process parameters.

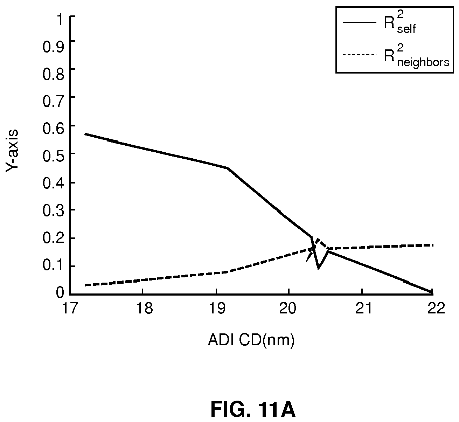

In an embodiment, a geometric shape of the feature can be a hole or a line. The correlation coefficient associated with a contact hole will be different from a line. For example, if a feature of interest is surrounded by a line, the loading effect may decrease along a length of the line. Also, a L shaped feature may have different correlation compared to a line, since L-shape has a corner and thus affected by neighboring feature differently than a line. In an embodiment, the correlation also depends on a critical dimension of the neighboring features. For example, larger the critical dimension of the neighboring features larger the loading effect (see Figure 11A).

In an embodiment, the correlation is computed using following equation:

$$R^2_{neighbors} = \vec{c}^T \cdot Q^{-1} \cdot \vec{c}$$

In the above equation, $\vec{c} = (r_{CDAEI,CDADI_1},...,r_{CDAEI,CDADI_6})^T$ is a vector of correlations, where $CDAEI$ is the AEI CD of the feature of interest; $CDADI_j$ is the ADI CD of the $i^{th}$ neighbor, and r is the correlation coefficient, and $Q_{i,j} = r_{CDADI_i,CDADI_j}$ is a correlation matrix. The above equation is an example and does not limit the correlation based on CD. As mentioned earlier, the correlation may be computed based on other physical characteristics (e.g., a geometric shape, a distance, assist features, etc., as mentioned earlier) associated with the feature of interest and the neighboring features.

In an example experiment, referring to Figure 10, a metrology tool (e.g., SEM) measured $10^5$ contact holes that were exposed at 7 conditions according to a focus-exposure matrix (FEM). The contact holes were on a hexagonal grid, and thus each contact hole (e.g., 1040) had 6 neighbors (e.g., 1050a-1050f). Then, an etch recipe (e.g., IMEC TITAN VIA etch) was used for etching the exposed substrate. Further, the CD values of the contact holes before and after etch were determined for example, using a MATLAB script configured to organize data for further use. Assuming a simple linear relation between the CD of the hole ADI and AEI correlation between ADI and AEI can be established. For example, a part of the variance of AEI CD explained by the ADI CD of the contact hole 1040 is then simply a square of a correlation coefficient ($R^2$) given below:

$$R^2_{self} = \left( \frac{Cov(CD_{AEI}, CD_{ADI})}{std(CD_{AEI}) \cdot std(CD_{ADI})} \right)^2$$

For the part of the variance of AEI CD explained by the ADI CD of the neighboring contact holes 1050a-1050f, a vector of correlations is used. An example vector of correlation $\vec{c}$ is given by:

$$\vec{c} = \left( r_{CDAEI,CDADI_1}, ..., r_{CDAEI,CDADI_6} \right)^T$$

Then $R^2_{neighbors}$ can be computed using:

$$R^2_{neighbors} = \vec{c}^T \cdot Q^{-1} \cdot \vec{c}$$

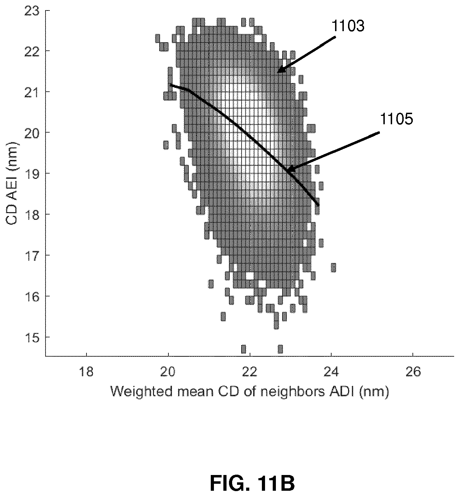

An example correlation is illustrated in Figure 11A and 11B. For the 7 conditions in the FEM, a correlation plot (in Figure 11A) shows the $R^2_{self}$ and $R^2_{neighbors}$ against the mean CD of the holes. The y-axis indicates a fraction of variation in AEI CD that is explained by either the ADI CD of the feature of interest itself or ADI CD of its neighbors. The y-axis can be a dimensionless quantity, or a percent if you multiply by 100). The correlation plot indicates that a short-range etch loading effect is strongest for the largest CD, and substantially lower for the relatively smaller CD. A short-range may be, for example, within an FOV of the SEM. Hence, the short-range etch loading does depend on the pattern density. In addition, Figure 11B shows a negative correlation indicating the etch loading effect also depends on FEM conditions.

In the present example of Figure 11B, the AEI CD (Y axis) is plotted against a weighted mean of the ADI CD of the neighbors (X axis) for the condition with the largest mean CD in figure 11A. The variations in CD represented by a grey region 1103 is due to random fluctuations in the patterning process and a line 1105 shows a moving average of CD of the feature of interest. The line 1105 shows a negative correlation between AEI CD and ADI CD of neighbours. A negative correlation indicates that the correlation between the etched feature and the neighboring features of the ADI is relatively high for the shown FEM condition, which prints at a relatively large average CD. To clarify, the relatively large average CD is not randomly larger CD's within the imaged pattern, but the CD associated with conditions or patterns that have a large pattern density because an average CD of that condition or pattern is large (e.g. if the scanner dose used is high or a mask design is such that the CD is large).

In an embodiment, the method involves determining, based on the correlation and at a given radial distance between the center of the substrate and the edge of the substrate, etch conditions associated with the imaged pattern so that the correlation remains within a target range. In an embodiment, the etch conditions depends on at least one of: a location of the substrate being etched, the location being the radial distance between the center of the substrate and the edge of the substrate (e.g., a center or an edge of the substrate or other distance to region of interest on the substrate); an etch cycle; an etch chamber; a sequence of the etching cycle and deposition step; or tuning parameters associated with the etch chamber, the tuning being based on a sensitivity of correlation to a change in the tuning parameter.

In an embodiment, determining, based on the correlation, etch conditions for the imaged pattern located at a center of a substrate so that the correlation is within the target range. In an embodiment, the method involves determining, based on the correlation, etch conditions for the imaged pattern located at an edge of the substrate so that the correlation remains within the target range. In general, even if a pattern density is same, different etch conditions may be needed at different locations on the substrate due to a thickness profile of the substrate, drifts associated with etching apparatus, etc.

In an embodiment, the etch conditions include etchant composition, plasma gas parameters, etching rate, electro-magnetic fields, a plasma potential, an inductive or a capacitive type of etching, a temperature of the substrate, ion energy distribution, ion angular distribution, parameters associated with sputtering and redeposition rates, an etch cycle parameter based on a saturation effect, or a combination thereof. In an embodiment, the saturation effect is a loading effect that can be used to determine the constituency of materials in the plasma as a means for endpoint detection per cycle. This could be used to trigger the next cycle.

In an embodiment, the etch conditions can be adjusted in comparison to an ideal etch condition. For example, an ideal etch condition can either be tweaked within an existing etch apparatus (e.g., adjusting parameters such as the etchant composition, plasma gas parameters, etching rate, etc.) or in a design tool used for determining an etch conditions, the design tool allows for adjusting parameters such as electromagnetic fields, capacitive or inductive type etching, etc. such that the correlation remains within a desired target range.

In an embodiment, the method further includes generating, based on the correlation between the AEI CD and ADI CD, a power spectral density of the correlation (e.g., a correlation established using a line as feature). The power spectral density is indicative of a magnitude of the etch characteristic effect (e.g., loading effect) and a range of the loading effect. In an embodiment, the power spectral density may be computed in a spatial domain (e.g., along a length of a line feature). For example, the power spectral density is computed by taking a Fourier transform of the correlation in the spatial domain, where the correlation is as a continuous function of the distance between two points. An example power density of the correlation for a line may indicate that the correlation is relatively higher at small spacing between the line segments, and gradually decreases for larger spacing between the line segments. Further, based on the power spectral density appropriate etching conditions may be determined. For example, an etch recipe may be defined based on the magnitude of the loading effect along the line such that the correlation between the ADI of the line and the AEI of the line is remains within a target range during the etching process.

In an embodiment, the correlation can be used for monitoring and controlling a performance of a patterning process, for example, by controlling an etch recipe and etch conditions (e.g., tuning parameters) such that the correlation remains in a target range.

For example, etch process chambers are monitored based on a critical dimension uniformity across an entire substrate, or a CD difference between different features at different radius across the substrate.

In an example, controlling involves determining an impact on CD not only based on selectable etch knobs, e.g. gas-pressure, power, DC, temperature, etc., but also the correlation. Then, a desired performance (e.g., whether the correlation remains in a target range) can be monitored. The benefit is that more dies of the substrate will be within the specification at the final yield test. Furthermore, the benefit of correlation based monitoring is that it may not be necessary to check a final yield again on e.g., e-test vehicles or die-hard inspection of millions of features.

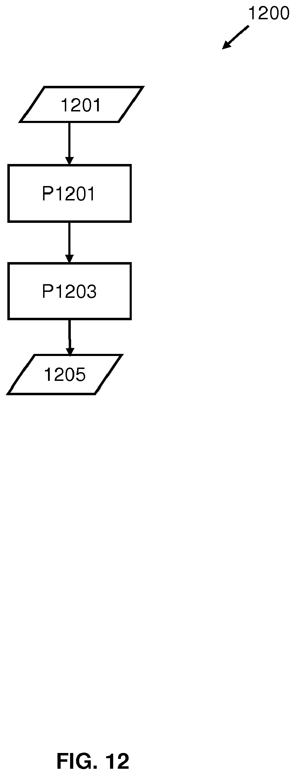

Figure 12 is a flow chart of a method 1200 of determining etch conditions associated with an etch process based on the correlation (discussed above) between an etched feature of interest and neighboring features in ADI. The method 1200 is used for monitoring and controlling an etching process based on a target range of the correlation. In an embodiment, a correlation target range (e.g., 0-0.4) may be defined and etch conditions can be defined such that the target range is met during or after etching process. The target range may be constant across the substrate being etched, but the etch conditions may vary at, e.g., the center and the edge of the substrate. The method 1200 is further discussed in detail below.

In an embodiment, the etch conditions are determined such that ranges a plurality of parameters (e.g., including correlation) related to loading effects are within a desired specification. For example, an impact of density fluctuations and the fraction of variance explained by ADI neighbors are also within the desired specification. For example, an extent of the loading effects: less than 100 nm; an impact density range: between 0.3 and 0.35 nm/nm; and an example fraction of variance explained: between 0.15 and 0.17.

Procedure P1201 involves obtaining a correlation 1201 between an etched feature of interest in an after etched image (AEI) and neighboring features associated with the etched feature of interest in an after development image (ADI). In an embodiment, the obtaining of the correlation is according to method of Figure 9. For example the obtaining of the correlation involves obtaining, via a metrology tool, (i) the after development image (ADI) of the imaged pattern at a given location, an imaged pattern including a feature of interest and neighboring features adjacent to the feature of interest, and (ii) the after etch image (AEI) of the imaged pattern at the given location, the AEI including the etched feature of interest corresponding to the feature of interest in the ADI; and determining, using the ADI and the AEI, the correlation between the etched feature and the neighboring features associated with the feature of interest in the ADI.

Procedure P1203 involves determining, based on the correlation, etch conditions 1205 associated with the etch process so that the correlation remains within a target range.

In an embodiment, the determining of the etch conditions depends on at least one of a location of the substrate being etched, the location being a center or an edge of the substrate; an etch cycle of the etch process; an etch chamber used in the etch process; a sequence of the etching cycle and deposition step; or tuning parameters associated with the etch chamber, the tuning being based on a sensitivity of correlation to a change in the tuning parameter.

In an embodiment, the determining of the etch conditions involve monitoring CDU across the substrate or a CD difference between instances of an etched feature of interest at different radius. For example, the etch conditions may be determined by changing selectable etch knobs, e.g. gas-pressure, power, DC, temperature, etc. and evaluating impact on CD as well as the correlation. An advantage of determining the etch condition based on the correlation is that more dies of the substrate will be within the specification at the final yield test compared to existing methods..

In an embodiment, an etch condition or an etch recipe can be described as having a beginning stage, middle stage(s) and an end stage. Each stage of the etch can be made up of one or more 'mini' etch recipes, which when taken altogether represent the etch recipe. In an embodiment, these 'mini' etch recipes are used to finely tune results (e.g., characterized by CD of etched feature of interest or yield) of the etch process. Accordingly, different 'mini' etch recipes that have slightly different behaviors such as, but not limited to, different amounts of loading, may be applied so that a desired end result (e.g., CD or yield) is achieved. In an embodiment, these fine tuning of etch recipes are achieved via tuning different plasma gas parameters, power settings, gas flow settings, etc.

Note that although 'mini' etch recipes can be defined, the etch process development is typically done based on a whole etch result and not on pieces that could be represented as the beginning, middle, end of the etch process. For example, an entire etch process may be executed without interruption or stopping at the beginning, middle or end of the etch process.

In an embodiment, when there are multiple materials on a substrate that are being etched, it is possible to have them all etched in a combined etch process in a single chamber where the etch recipe for a first material would be comprised of multiple steps and then followed by another etch recipe for a second material which may be comprised of a different set of multiple steps (also including changes to gases, etc). For multi-material etches, there can be different degrees of anisotropy desired for each material, such that a profile of the etched pattern is not a perfect copy from one material to the next. These differences could result in different correlation results. It is possible (but also uncommon) to stop an etch between layers to observe the individual profile of a multi-profile etch. In an embodiment, an etch profile may be characterized by geometry of the etched feature such as a height, an angle, a width associated with the etched feature.

In an embodiment, the determining of the etch conditions involves adjusting values of the tuning parameters associated with a given etch chamber such that the correlation associated with the given imaged pattern remains within the target range.

The measurements (e.g., ADI CD and AEI CD) according to present disclosure help understanding the etch process, which can speed up an etch optimization process, even if manual. For example, optimization based on the correlation obtained from method of Figure 3. As the measurements are performed on product structures, the resulting etch is better optimized for the most critical structures thereby increasing the yield of the patterning process.

In an embodiment, a computer program may be coded and implemented on a process to implements various steps of the methods discussed herein. For example, a computer program may be configured to simulate a patterning process (e.g., lithography step, etching, resist development, etc.). Then, based on the simulation results, it is possible to calibrate individual parameters according to, e.g., the correlation between results of different process (e.g., after resist development and after etch development) discussed in the methods described herein. In an embodiment, simulation based tuning or calibration can also provide insights during manual tuning of an etch process. For example, insights related to effect of change in a process parameter on the correlation.

In an embodiment, the methods discussed above (e.g. methods 400 and 900) may be implemented via a process (e.g., 104 of the computer system 100). In an embodiment, a computer program product comprises a non-transitory computer readable medium having instructions recorded thereon, the instructions when executed by a computer implementing procedures of the method discussed herein.

In some embodiments, the inspection apparatus may be a scanning electron microscope (SEM) that yields an image of a structure (e.g., some or all the structure of a device) exposed or transferred on the substrate. Figure 13 depicts an embodiment of a SEM tool. A primary electron beam EBP emitted from an electron source ESO is converged by condenser lens CL and then passes through a beam deflector EBD1, an E x B deflector EBD2, and an objective lens OL to irradiate a substrate PSub on a substrate table ST at a focus.

When the substrate PSub is irradiated with electron beam EBP, secondary electrons are generated from the substrate PSub. The secondary electrons are deflected by the E x B deflector EBD2 and detected by a secondary electron detector SED. A two-dimensional electron beam image can be obtained by detecting the electrons generated from the sample in synchronization with, e.g., two dimensional scanning of the electron beam by beam deflector EBD1 or with repetitive scanning of electron beam EBP by beam deflector EBD1 in an X or Y direction, together with continuous movement of the substrate PSub by the substrate table ST in the other of the X or Y direction.

A signal detected by secondary electron detector SED is converted to a digital signal by an analog/digital (A/D) converter ADC, and the digital signal is sent to an image processing system IPU. In an embodiment, the image processing system IPU may have memory MEM to store all or part of digital images for processing by a processing unit PU. The processing unit PU (e.g., specially designed hardware or a combination of hardware and software) is configured to convert or process the digital images into datasets representative of the digital images. Further, image processing system IPU may have a storage medium STOR configured to store the digital images and corresponding datasets in a reference database. A display device DIS may be connected with the image processing system IPU, so that an operator can conduct necessary operation of the equipment with the help of a graphical user interface.

As noted above, SEM images may be processed to extract contours that describe the edges of objects, representing device structures, in the image. These contours are then quantified via metrics, such as CD. Thus, typically, the images of device structures are compared and quantified via simplistic metrics, such as an edge-to-edge distance (CD) or simple pixel differences between images. Typical contour models that detect the edges of the objects in an image in order to measure CD use image gradients. Indeed, those models rely on strong image gradients. But, in practice, the image typically is noisy and has discontinuous boundaries. Techniques, such as smoothing, adaptive thresholding, edge-detection, erosion, and dilation, may be used to process the results of the image gradient contour models to address noisy and discontinuous images, but will ultimately result in a low-resolution quantification of a high-resolution image. Thus, in most instances, mathematical manipulation of images of device structures to reduce noise and automate edge detection results in loss of resolution of the image, thereby resulting in loss of information. Consequently, the result is a low-resolution quantification that amounts to a simplistic representation of a complicated, high-resolution structure.

So, it is desirable to have a mathematical representation of the structures (e.g., circuit features, alignment mark or metrology target portions (e.g., grating features), etc.) produced or expected to be produced using a patterning process, whether, e.g., the structures are in a latent resist image, in a developed resist image or transferred to a layer on the substrate, e.g., by etching, that can preserve the resolution and yet describe the general shape of the structures. In the context of lithography or other pattering processes, the structure may be a device or a portion thereof that is being manufactured and the images may be SEM images of the structure. In some instances, the structure may be a feature of semiconductor device, e.g., integrated circuit. In this case, the structure may be referred as a pattern or a desired pattern that comprises a plurality of feature of the semiconductor device. In some instances, the structure may be an alignment mark, or a portion thereof (e.g., a grating of the alignment mark), that is used in an alignment measurement process to determine alignment of an object (e.g., a substrate) with another object (e.g., a patterning device) or a metrology target, or a portion thereof (e.g., a grating of the metrology target), that is used to measure a parameter (e.g., overlay, focus, dose, etc.) of the patterning process. In an embodiment, the metrology target is a diffractive grating used to measure, e.g., overlay.

Figure 14 schematically illustrates a further embodiment of an inspection apparatus. The system is used to inspect a sample 90 (such as a substrate) on a sample stage 88 and comprises a charged particle beam generator 81, a condenser lens module 82, a probe forming objective lens module 83, a charged particle beam deflection module 84, a secondary charged particle detector module 85, and an image forming module 86.

The charged particle beam generator 81 generates a primary charged particle beam 91. The condenser lens module 82 condenses the generated primary charged particle beam 91. The probe forming objective lens module 83 focuses the condensed primary charged particle beam into a charged particle beam probe 92. The charged particle beam deflection module 84 scans the formed charged particle beam probe 92 across the surface of an area of interest on the sample 90 secured on the sample stage 88. In an embodiment, the charged particle beam generator 81, the condenser lens module 82 and the probe forming objective lens module 83, or their equivalent designs, alternatives or any combination thereof, together form a charged particle beam probe generator which generates the scanning charged particle beam probe 92.

The secondary charged particle detector module 85 detects secondary charged particles 93 emitted from the sample surface (maybe also along with other reflected or scattered charged particles from the sample surface) upon being bombarded by the charged particle beam probe 92 to generate a secondary charged particle detection signal 94. The image forming module 86 (e.g., a computing device) is coupled with the secondary charged particle detector module 85 to receive the secondary charged particle detection signal 94 from the secondary charged particle detector module 85 and accordingly forming at least one scanned image. In an embodiment, the secondary charged particle detector module 85 and image forming module 86, or their equivalent designs, alternatives or any combination thereof, together form an image forming apparatus which forms a scanned image from detected secondary charged particles emitted from sample 90 being bombarded by the charged particle beam probe 92.

In an embodiment, a monitoring module 87 is coupled to the image forming module 86 of the image forming apparatus to monitor, control, etc. the patterning process and/or derive a parameter for patterning process design, control, monitoring, etc. using the scanned image of the sample 90 received from image forming module 86. So, in an embodiment, the monitoring module 87 is configured or programmed to cause execution of a method described herein. In an embodiment, the monitoring module 87 comprises a computing device. In an embodiment, the monitoring module 87 comprises a computer program to provide functionality herein and encoded on a computer readable medium forming, or disposed within, the monitoring module 87.

In an embodiment, like the electron beam inspection tool of Figure 13 that uses a probe to inspect a substrate, the electron current in the system of Figure 14 is significantly larger compared to, e.g., a CD SEM such as depicted in Figure 13, such that the probe spot is large enough so that the inspection speed can be fast. However, the resolution may not be as high as compared to a CD SEM because of the large probe spot. In an embodiment, the above discussed inspection apparatus may be single beam or a multi-beam apparatus without limiting the scope of the present disclosure.

The SEM images, from, e.g., the system of Figure 13 and/or Figure 14, may be processed to extract contours that describe the edges of objects, representing device structures, in the image. These contours are then typically quantified via metrics, such as CD, at user-defined cut-lines. Thus, typically, the images of device structures are compared and quantified via metrics, such as an edge-to-edge distance (CD) measured on extracted contours or simple pixel differences between images.

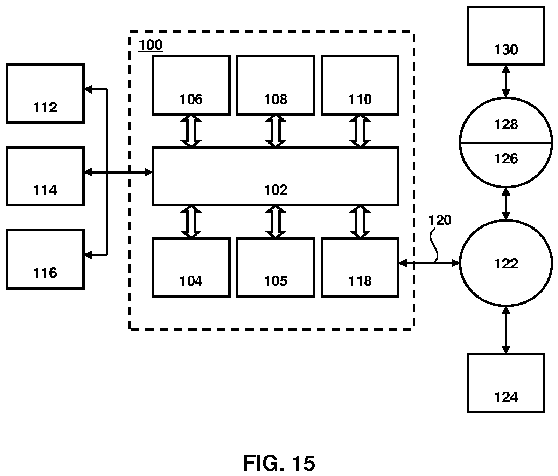

Figure 15 is a block diagram that illustrates a computer system 100 which can assist in implementing methods and flows disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of the process may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 also desirably includes a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are example forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide for the illumination optimization of the embodiment, for example. The received code may be executed by processor 104 as it is received, and/or stored in storage device 110, or other non-volatile storage for later execution. In this manner, computer system 100 may obtain application code in the form of a carrier wave.

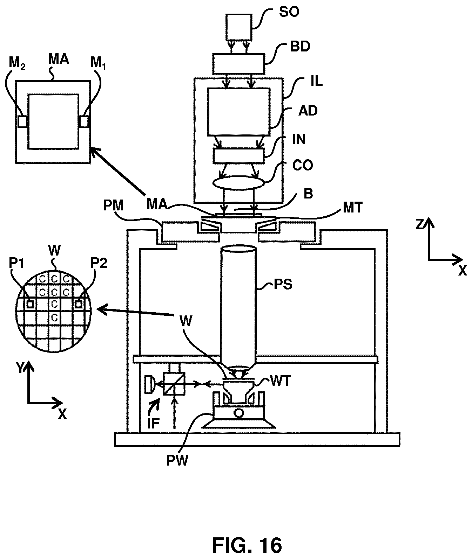

Figure 16 schematically depicts an exemplary lithographic projection apparatus in conjunction with the techniques described herein can be utilized. The apparatus comprises:

-    an illumination system IL, to condition a beam B of radiation. In this particular case, the illumination system also comprises a radiation source SO;

- a first object table (e.g., patterning device table) MT provided with a patterning device holder to hold a patterning device MA (e.g., a reticle), and connected to a first positioner to accurately position the patterning device with respect to item PS;
- a second object table (substrate table) WT provided with a substrate holder to hold a substrate W (e.g., a resist-coated silicon wafer), and connected to a second positioner to accurately position the substrate with respect to item PS;
- a projection system ("lens") PS (e.g., a refractive, catoptric or catadioptric optical system) to image an irradiated portion of the patterning device MA onto a target portion C (e.g., comprising one or more dies) of the substrate W.

As depicted herein, the apparatus is of a transmissive type (i.e., has a transmissive patterning device). However, in general, it may also be of a reflective type, for example (with a reflective patterning device). The apparatus may employ a different kind of patterning device to classic mask; examples include a programmable mirror array or LCD matrix.

The source SO (e.g., a mercury lamp or excimer laser, LPP (laser produced plasma) EUV source) produces a beam of radiation. This beam is fed into an illumination system (illuminator) IL, either directly or after having traversed conditioning means, such as a beam expander Ex, for example. The illuminator IL may comprise adjusting means AD for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam B impinging on the patterning device MA has a desired uniformity and intensity distribution in its cross-section.

It should be noted with regard to Figure 16 that the source SO may be within the housing of the lithographic projection apparatus (as is often the case when the source SO is a mercury lamp, for example), but that it may also be remote from the lithographic projection apparatus, the radiation beam that it produces being led into the apparatus (e.g., with the aid of suitable directing mirrors); this latter scenario is often the case when the source SO is an excimer laser (e.g., based on KrF, ArF or $F_2$ lasing).

The beam PB subsequently intercepts the patterning device MA, which is held on a patterning device table MT. Having traversed the patterning device MA, the beam B passes through the lens PL, which focuses the beam B onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the patterning device MA with respect to the path of the beam B, e.g., after mechanical retrieval of the patterning device MA from a patterning device library, or during a scan. In general, movement of the object tables MT, WT will be realized with the aid of a long-stroke module (coarse positioning) and a short-stroke module (fine positioning), which are not explicitly depicted in Figure 16. However, in the case of a stepper (as opposed to a step-and-scan tool) the patterning device table MT may just be connected to a short stroke actuator, or may be fixed.

The depicted tool can be used in two different modes:

- In step mode, the patterning device table MT is kept essentially stationary, and an entire patterning device image is projected in one go (i.e., a single "flash") onto a target portion C. The substrate table WT is then shifted in the x and/or y directions so that a different target portion C can be irradiated by the beam PB;
- In scan mode, essentially the same scenario applies, except that a given target portion C is not exposed in a single "flash". Instead, the patterning device table MT is movable in a given direction (the so-called "scan direction", e.g., the y direction) with a speed v, so that the projection beam B is caused to scan over a patterning device image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

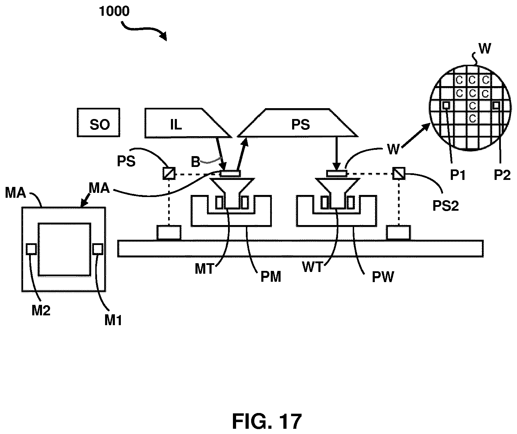

Figure 17 schematically depicts another exemplary lithographic projection apparatus 1000 that includes:

- a source collector module SO to provide radiation.
- an illumination system (illuminator) IL configured to condition a radiation beam B (e.g. EUV radiation) from the source collector module SO.
- a support structure (e.g. a mask table) MT constructed to support a patterning device (e.g. a mask or a reticle) MA and connected to a first positioner PM configured to accurately position the patterning device;
- a substrate table (e.g. a wafer table) WT constructed to hold a substrate (e.g. a resist coated wafer) W and connected to a second positioner PW configured to accurately position the substrate; and
- a projection system (e.g. a reflective projection system) PS configured to project a pattern imparted to the radiation beam B by patterning device MA onto a target portion C (e.g. comprising one or more dies) of the substrate W.

As here depicted, the apparatus 1000 is of a reflective type (e.g. employing a reflective mask). It is to be noted that because most materials are absorptive within the EUV wavelength range, the patterning device may have multilayer reflectors comprising, for example, a multi-layer stack of molybdenum and silicon. In one example, the multi-stack reflector has a 40 layer pairs of Molybdenum and Silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multi-layer reflector) defines where features would print (positive resist) or not print (negative resist).

Referring to Figure 17, the illuminator IL receives an extreme ultra violet radiation beam from the source collector module SO. Methods to produce EUV radiation include, but are not necessarily limited to, converting a material into a plasma state that has at least one element, e.g., xenon, lithium or tin, with one or more emission lines in the EUV range. In one such method, often termed laser produced plasma ("LPP") the plasma can be produced by irradiating a fuel, such as a droplet, stream or cluster of material having the line-emitting element, with a laser beam. The source collector module SO may be part of an EUV radiation system including a laser, not shown in Figure 17, for providing the laser beam exciting the fuel. The resulting plasma emits output radiation, e.g., EUV radiation, which is collected using a radiation collector, disposed in the source collector module. The laser and the source collector module may be separate entities, for example when a CO2 laser is used to provide the laser beam for fuel excitation.

In such cases, the laser is not considered to form part of the lithographic apparatus and the radiation beam is passed from the laser to the source collector module with the aid of a beam delivery system comprising, for example, suitable directing mirrors and/or a beam expander. In other cases the radiation source may be an integral part of the source collector module, for example when the radiation source is a discharge produced plasma EUV generator, often termed as a DPP radiation source.

The illuminator IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B is incident on the patterning device (e.g., mask) MA, which is held on the support structure (e.g., mask table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder or capacitive sensor), the substrate table WT can be moved accurately, e.g. so as to position different target portions C in the path of the radiation beam B. Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks PI, P2.

The depicted apparatus 1000 could be used in at least one of the following modes:

1. In step mode, the support structure (e.g. mask table) MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed.

2. In scan mode, the support structure (e.g. mask table) MT and the substrate table WT are scanned synchronously while a pattern imparted to the radiation beam is projected onto a target portion C (i.e. a single dynamic exposure). The velocity and direction of the substrate table WT relative to the support structure (e.g. mask table) MT may be determined by the (de-)magnification and image reversal characteristics of the projection system PS.

3. In another mode, the support structure (e.g. mask table) MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

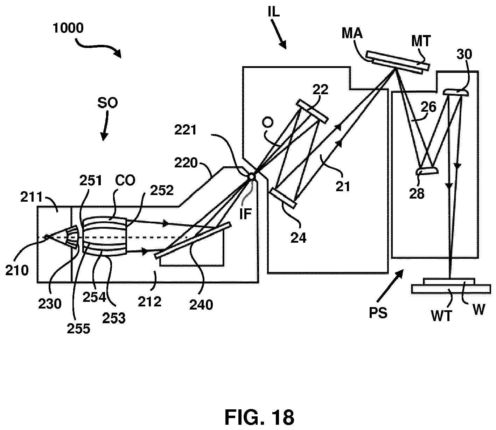

Figure 18 shows the apparatus 1000 in more detail, including the source collector module SO, the illumination system IL, and the projection system PS. The source collector module SO is constructed and arranged such that a vacuum environment can be maintained in an enclosing structure 220 of the source collector module SO. An EUV radiation emitting plasma 210 may be formed by a discharge produced plasma radiation source. EUV radiation may be produced by a gas or vapor, for example Xe gas, Li vapor or Sn vapor in which the very hot plasma 210 is created to emit radiation in the EUV range of the electromagnetic spectrum. The very hot plasma 210 is created by, for example, an electrical discharge causing an at least partially ionized plasma. Partial pressures of, for example, 10 Pa of Xe, Li, Sn vapor or any other suitable gas or vapor may be required for efficient generation of the radiation. In an embodiment, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure. The contaminant trap or contaminant barrier 230 further indicated herein at least includes a channel structure, as known in the art.

The collector chamber 211 may include a radiation collector CO which may be a so-called grazing incidence collector. Radiation collector CO has an upstream radiation collector side 251 and a downstream radiation collector side 252. Radiation that traverses collector CO can be reflected off a grating spectral filter 240 to be focused in a virtual source point IF along the optical axis indicated by the dot-dashed line 'O'. The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the beam of radiation 21 at the patterning device MA, held by the support structure MT, a patterned beam 26 is formed and the patterned beam 26 is imaged by the projection system PS via reflective elements 28, 30 onto a substrate W held by the substrate table WT.

More elements than shown may generally be present in illumination optics unit IL and projection system PS. The grating spectral filter 240 may optionally be present, depending upon the type of lithographic apparatus. Further, there may be more mirrors present than those shown in the Figures, for example there may be 1-6 additional reflective elements present in the projection system PS than shown in Figure 18.

Collector optic CO, as illustrated in Figure 18, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type is desirably used in combination with a discharge produced plasma radiation source.

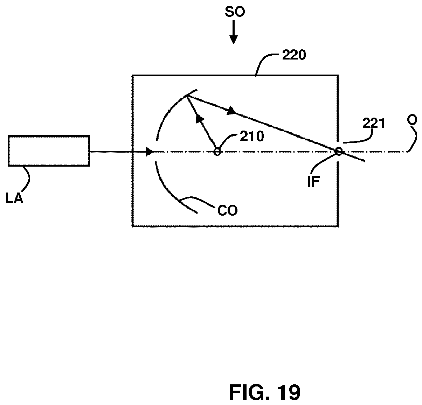

Alternatively, the source collector module SO may be part of an LPP radiation system as shown in Figure 19. A laser LAS is arranged to deposit laser energy into a fuel, such as xenon (Xe), tin (Sn) or lithium (Li), creating the highly ionized plasma 210 with electron temperatures of several 10's of eV. The energetic radiation generated during de-excitation and recombination of these ions is emitted from the plasma, collected by a near normal incidence collector optic CO and focused onto the opening 221 in the enclosing structure 220.

The embodiments may further be described using the following clauses:

1. A method of training a model configured to predict whether a feature associated with an imaged substrate will be defective after etching of the imaged substrate, the method comprising:

obtaining, via a metrology tool, (i) an after development image of the imaged substrate at a given location, the after development image including a plurality of features, and (ii) an after etch image of the imaged substrate at the given location, the after etch image including etched features corresponding to the plurality of features; and
training, using the after development image and the after etch image, the model configured to determine defectiveness of a given feature of the plurality of features in the after development image,
wherein the determining of defectiveness is based on comparing the given feature in the after development image with a corresponding etch feature in the after etch image.

2. The method of clause 1, wherein the model is an empirical model or a machine learning model, wherein the empirical model is a function of a physical characteristic of the feature associated with the imaged substrate.

3. The method of any of clauses 1 to 2, wherein the obtaining of the after development image comprises:

imaging, via a patterning apparatus, a mask pattern on a substrate;
obtaining a developed substrate of the imaged substrate;
aligning the metrology tool to the developed substrate at the given location; and
capturing an image of the developed substrate.

4. The method of any of clauses 1 to 3, wherein the obtaining of the after etched image comprises:

etching, via an etch process with specified etch conditions, the imaged substrate;
aligning the metrology tool to the etched substrate at the given location; and
capturing the after etched image of the etched substrate.

5. The method of clause 4, wherein the etch conditions include etchant composition, plasma gas parameters, etching rate, electro-magnetic fields, a plasma potential, an inductive or a capacitive type of etching, a temperature of the substrate, ion energy distribution, ion angular distribution, sputtering and redeposition rates, or a combination thereof.

6. The method of any of clauses 1 to 5, wherein the training comprises:

aligning, based on the plurality of features, the after development image and the after etch image;
comparing each of the features of the plurality of features in the after development image with the corresponding features in the after etch image;
determining, based on the comparison, whether a given etched feature in the after etch image satisfy a defect condition;
responsive to not satisfying the defect condition, classifying the identified feature as defective; and
adjusting model parameter values of the model based on the defectiveness of the identified feature.

7. The method of clause 6, wherein the defective condition is at least one of:

grey scale values in an enclosed contour within the after etch image; and
a physical characteristic of the given etched feature in the after etch image.

8. The method of clause 7, wherein the physical characteristic is at least one of:

a critical dimension of the given etched feature; or
a displacement of the given etched feature with respect to the given feature of the after development image.

9. The method of any of clauses 1 to 8, wherein the defectiveness is characterized by at least one of:

a binary determination of defective or not defective; or
a probability of the given feature being defective.

10. The method of any of clauses 2 to 9, wherein the machine learning model is a convolution neural network.

11. The method of clause 10, wherein the model parameters are weights and/or bias associated with one or more layers of the machine learning model.

12. The method of any of clauses 1 to 11, wherein the metrology tool is a scanning electron microscope (SEM) and the measure values are obtained from a SEM image.

13. The method of any of clauses 1 to 12, wherein the trained model is further configured to predict a failure rate associated with the given pattern of the after development image, the failure rate being indicative of a defect occurrence when the imaged substrate is etched using the specified etch conditions.

14. The method of any of clauses 1 to 13, wherein the further configuring of the training model comprises:

classifying the plurality of patterns associated with a pattern of interest as defective or not defective;
determining a total number of defective patterns associated with the pattern of interest; and
computing the failure rate of the pattern of interest as ratio of the total number of defective pattern and a total number of patterns in the plurality of patterns.

15. The method of any of clauses 1 to 14, further comprising:

imaging, via a patterning apparatus, a desired pattern on a substrate;
obtaining an after development image of the imaged pattern;
executing the training model using the after development image to classify whether the desired pattern will be defective after etching; and
adjusting, based on the classified defective pattern, an etching condition such that imaged pattern will not be defective after etching.

16. A method for determining etch conditions for an imaged substrate, the method comprising:

obtaining an after development image of the imaged substrate, and initial etch conditions to be used for etching the imaged substrate;
determining, via a trained model using the after development image and the initial etch conditions, a failure rate of a feature associated with the imaged substrate, the failure rate being indicative of the feature being defective after etching of the imaged substrate; and

modifying, based on the failure rate, the initial etch conditions such that chances of the feature being defective after etching is reduced.

17. The method of clause 16, wherein the modifying the etch conditions is an iterative process, an iteration comprises:

obtaining a relationship between a given etch condition and a given failure rate associated with a given feature;

determining, via executing an etch model using the after development image and the etch conditions, an after etch image associated with the imaged substrate,

determining, based on the after etch image, whether the given feature satisfies a defect condition; and

responsive to not satisfying the defect condition, identifying, based on the relationship, another etch conditions associated with a lower failure rate compared to the failure rate.

18. The method of any of clauses 16 to 17, wherein the defect condition of the feature at least one of:

an omission of the feature;

a displacement range associated with the feature; or

a tolerance range associated with critical dimension of the feature.

19. A method of determining etch characteristic associated with an etch process, the method comprising:

obtaining, via a metrology tool, (i) an after development image (ADI) of an imaged pattern at a given location of a substrate, the imaged pattern includes at least one feature of interest and neighboring features adjacent to the at least one feature of interest, and (ii) an after etch image (AEI) of the imaged pattern at the given location of the substrate, the AEI includes an etched feature corresponding to the at least one feature of interest in the ADI; and

determining, using the ADI and the AEI, a correlation between the etched feature and the neighboring features associated with the at least one feature of interest in the ADI, the correlation characterizes the etch characteristic associated with the etching process.

20. The method of clause 19, wherein the correlation is a function of a density of the neighboring features adjacent to the at least one feature of interest.

21. The method of any of clauses 19 to 20, wherein the correlation between the etched feature and the neighboring features in the ADI depends on at least one of:

a geometric shape of the at least one feature of interest or the neighboring features;

a geometric shape of assist features or bias associated with the at least one feature of interest;

a distance between the at least one feature of interest and the neighboring features;

a distance along a line feature;

a critical dimension of the at least one feature;

coordinates on the substrate associated with the at least one feature of interest, the neighboring features, and the etched feature of interest;

assist features or lack of assist features around the at least one feature of interest; or

a deviation of an edge position from its expected position associated with the at least one feature of interest.

22. The method of any of clauses 19 to 21, wherein the correlation based on the critical dimension of a feature is computed using following equation:

$$R^2_{neighbors} = \vec{c}^{\,T} \cdot Q^{-1} \cdot \vec{c}$$

wherein $\vec{c} = (r_{CDAEI,CDADI_1}, \ldots, r_{CDAEI,CDADI_6})^T$ is a vector of correlations, where $CDAEI$ is the AEI CD of the feature of interest; $CDADI_i$ is the ADI CD of the $i^{th}$ neighbor; and $r$ is the correlation coefficient, and $Q_{i,j} = r_{CDADI_i,CDADI_j}$ is a correlation matrix.

23. The method of any of clauses 19 to 22, wherein the at least one feature of interest is at least one of:

a contact hole;

a line; or

line ends.

24. The method of any of clauses 19 to 23, wherein the neighboring features are at least one of:

a plurality of contact holes at a defined orientation with respect to the feature of interest; or

a plurality of lines with a defined pitch.

25. The method of any of clauses 19 to 24, further comprising:

generating a power spectral density of the correlation in a spatial domain, the power spectral density being indicative of a magnitude of the etch characteristic effect and a range of the loading effect.

26. The method of any of clauses 19 to 25, further comprising determining, based on the correlation and at a given radial distance between the center of the substrate and the edge of the substrate, etch conditions associated with the imaged pattern so that the correlation remains within a target range.

27. The method of any of clauses 19 to 26, further comprising determining, based on the correlation, etch conditions for the imaged pattern located at a center of a substrate so that the correlation is within the target range.

28. The method of any of clauses 19 to 27, further comprising determining, based on the correlation, etch conditions for the imaged pattern located at an edge of the substrate so that the correlation remains within the target range.

29. The method of any of clauses 27 to 28, wherein the etch conditions include etchant composition, plasma gas parameters, etching rate, electro-magnetic fields, a plasma potential, an inductive or a capacitive type of etching, a temperature of the substrate, ion energy distribution, ion angular distribution, parameters associated with sputtering and redeposition rates, an etch cycle parameter based on a saturation effect, or a combination thereof.

30. The method of any of clauses 26 to 29, wherein the etch conditions depends on at least one of:

> a location of the substrate being etched, the location being the radial distance between the center of the substrate and the edge of the substrate;
> an etch cycle;
> an etch chamber;
> a sequence of the etching cycle and deposition step; or
> tuning parameters associated with the etch chamber, the tuning being based on a sensitivity of correlation to a change in the tuning parameter.

31. The method of any of clauses 26 to 30, wherein the determining of the correlation comprises:

> obtaining (i) a plurality of ADI at a plurality of given locations of the substrate, each ADI having a same feature of interest, and (ii) a plurality of AEI at the plurality of the given locations, each AEI having the etched feature of interest corresponding to the feature of interest;
> establishing the correlation between the neighboring features of the feature of interest in each ADI and the etched feature of interest in each of the AEI.

32. A method of determining etch conditions associated with an etch process, the method comprising:

> obtaining a correlation between an etched feature of interest in an after etched image (AEI) and neighboring features associated with the etched feature of interest in an after development image (ADI); and

> determining, based on the correlation, etch conditions associated with the etch process so that the correlation remains within a target range.

33. The method of clause 32, wherein the determining of the etch conditions depends on at least one of:

> a location of the substrate being etched, the location being a radial distance between the center of the substrate and the edge of the substrate;
> an etch cycle of the etch process;
> an etch chamber used in the etch process;
> a sequence of the etching cycle and deposition step; or
> tuning parameters associated with the etch chamber tuning parameters associated with the etch chamber, the tuning being based on a sensitivity of correlation to a change in the tuning parameter.

34. The method of clauses 32 to 33, wherein the determining of the etch conditions comprises: adjusting values of the tuning parameters associated with a given etch chamber such that the correlation associated with the given imaged pattern remains within the target range.

35. The method of any of clauses 32 to 34, wherein the obtaining of the correlation comprises:

> obtaining, via a metrology tool, (i) the after development image (ADI) of the imaged pattern at a given location, an imaged pattern including a feature of interest and neighboring features adjacent to the feature of interest, and (ii) the after etch image (AEI) of the imaged pattern at the given location, the AEI including the etched feature of interest corresponding to the feature of interest in the ADI; and
> determining, using the ADI and the AEI, the correlation between the etched feature and the neighboring features associated with the feature of interest in the ADI.

36. A computer program product comprising a non-transitory computer readable medium having instructions recorded thereon, the instructions when executed by a computer implementing the method of any of the above clauses.

The concepts disclosed herein may simulate or mathematically model any generic imaging system for imaging sub wavelength features, and may be especially useful with emerging imaging technologies capable of producing wavelengths of an increasingly smaller size. Emerging technologies already in use include EUV (extreme ultra violet) lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

Although specific reference may be made in this text to the use of embodiments in the manufacture of ICs, it should be understood that the embodiments herein may have many other possible applications. For example, it may be employed in the manufacture of integrated optical systems, guidance and detection patterns for magnetic domain memories, liquid-crystal displays (LCDs), thin film magnetic heads, micromechanical systems (MEMs), etc. The skilled artisan will appreciate that, in the context of such alternative applications, any use of the terms "reticle", "wafer" or "die" herein may be considered as synonymous or interchangeable with the more general terms "patterning device", "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create, for example, a multilayer IC, so that the term substrate used herein may also refer to a substrate that already contains multiple processed layers.

In the present document, the terms "radiation" and "beam" as used herein encompass all types of electromagnetic radiation, including ultraviolet radiation (e.g. with a wavelength of about 365, about 248, about 193, about 157 or about 126 nm) and extreme ultra-violet (EUV) radiation (e.g. having a wavelength in the range of 5-20 nm), as well as particle beams, such as ion beams or electron beams.

The terms "optimizing" and "optimization" as used herein refers to or means adjusting a patterning apparatus (e.g., a lithography apparatus), a patterning process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters.

"Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g. a disk) or an intangible carrier medium (e.g. a communications signal). Embodiments of the invention may be implemented using suitable apparatus which may specifically take the form of a programmable computer running a computer program arranged to implement a method as described herein. Thus, embodiments of the disclosure may be implemented in hardware, firmware, software, or any combination thereof. Embodiments of the disclosure may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

As used herein, unless specifically stated otherwise, the term "or" encompasses all possible combinations, except where infeasible. For example, if it is stated that a database can include A or B, then, unless specifically stated otherwise or infeasible, the database can include A, or B, or A and B. As a second example, if it is stated that a database can include A, B, or C, then, unless specifically stated otherwise or infeasible, the database can include A, or B, or C, or A and B, or A and C, or B and C, or A and B and C.

The descriptions above are intended to be illustrative, not limiting. Thus, it will be apparent to one skilled in the art that modifications may be made as described without departing from the scope of the claims set out below.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

To the extent certain U.S. patents, U.S. patent applications, or other materials (e.g., articles) have been incorporated by reference, the text of such U.S. patents, U.S. patent applications, and other materials is only incorporated by reference to the extent that no conflict exists between such material and the statements and drawings set forth herein. In the event of such conflict, any such conflicting text in such incorporated by reference U.S. patents, U.S. patent applications, and other materials is specifically not incorporated by reference herein.

While certain embodiments have been described, these embodiments have been presented by way of example only, and are not intended to limit the scope of the present disclosures. Indeed, the novel methods, apparatuses and systems described herein can be embodied in a variety of other forms; furthermore, various omissions, substitutions and changes in the form of the methods, apparatuses and systems described herein can be made without departing from the spirit of the present disclosures. The accompanying claims and their equivalents are intended to cover such forms or modifications as would fall within the scope and spirit of the present disclosures.

## Claims

1. A method of training a model configured to predict whether a feature associated with an imaged substrate will be defective after etching of the imaged substrate, the method comprising:

obtaining, via a metrology tool, (i) an after development image of the imaged substrate at a given location, the after development image including a plurality of features, and (ii) an after etch image of the imaged substrate at the given location, the after etch image including etched features corresponding to the plurality of features; and

training, using the after development image and the after etch image, the model configured to determine defectiveness of a given feature of the plurality of features in the after development image,

wherein the determining of defectiveness is based on comparing the given feature in the after development image with a corresponding etch feature in the after etch image.

2. The method of claim 1, wherein the model is an empirical model or a machine learning model, wherein the empirical model is a function of a physical characteristic of the feature associated with the imaged substrate.

3. The method of claim 1, wherein the obtaining of the after development image comprises:

imaging, via a patterning apparatus, a mask pattern on a substrate;
obtaining a developed substrate of the imaged substrate;
aligning the metrology tool to the developed substrate at the given location; and
capturing an image of the developed substrate.

4. The method of claim 1, wherein the obtaining of the after etched image comprises:

etching, via an etch process with specified etch conditions, the imaged substrate;
aligning the metrology tool to the etched substrate at the given location; and
capturing the after etched image of the etched substrate.

5. The method of claim 4, wherein the etch conditions include etchant composition, plasma gas parameters, etching rate, electro-magnetic fields, a plasma potential, an inductive or a capacitive type of etching, a temperature of the substrate, ion energy distribution, ion angular distribution, sputtering and redeposition rates, or a combination thereof.

6. The method of claim 1, wherein the training comprises:

aligning, based on the plurality of features, the after development image and the after etch image;
comparing each of the features of the plurality of features in the after development image with the corresponding features in the after etch image;
determining, based on the comparison, whether a given etched feature in the after etch image satisfy a defect condition;
responsive to not satisfying the defect condition, classifying the identified feature as defective; and
adjusting model parameter values of the model based on the defectiveness of the identified feature.

7. The method of claim 6, wherein the defective condition is at least one of:

grey scale values in an enclosed contour within the after etch image; and
a physical characteristic of the given etched feature in the after etch image.

8. The method of claim 7, wherein the physical characteristic is at least one of:

a critical dimension of the given etched feature; or
a displacement of the given etched feature with respect to the given feature of the after development image.

9. The method of claim 1, wherein the defectiveness is **characterized by** at least one of:

a binary determination of defective or not defective; or
a probability of the given feature being defective.

10. The method of claim 2, wherein the machine learning model is a convolution neural network.

11. The method of claim 10, wherein the model parameters are weights and/or bias associated with one or more layers of the machine learning model.

12. The method of claim 1, wherein the metrology tool is a scanning electron microscope (SEM) and the measure values are obtained from a SEM image.

13. The method of claim 1, wherein the trained model is further configured to predict a failure rate associated with the given pattern of the after development image, the failure rate being indicative of a defect occurrence when the imaged substrate is etched using the specified etch conditions.

14. The method of claim 13, wherein the further configuring of the training model comprises:

> classifying the plurality of patterns associated with a pattern of interest as defective or not defective;
> determining a total number of defective patterns associated with the pattern of interest; and
> computing the failure rate of the pattern of interest as ratio of the total number of defective pattern and a total number of patterns in the plurality of patterns.

15. A computer program product comprising a non-transitory computer readable medium having instructions recorded thereon, the instructions when executed by a computer implementing the method of claim 1.

**FIG. 1**

**FIG. 2**

**FIG. 3**

400

401 402

P401

P403

403

P405

P407

P409

FIG. 4A

```
                        ┌──────────┐
                       /   411    /
                      └──────────┘
                           │
                           ▼
                    ┌──────────────┐
                    │     P411     │
                    └──────────────┘
                           │
                           ▼
   ┌──────────┐     ┌──────────────┐
  /   413    /─────▶│     P413     │
 └──────────┘       └──────────────┘
                           │
                           ▼
   ┌──────────┐     ┌──────────────┐
  /   403    /─────▶│     P415     │
 └──────────┘       └──────────────┘
                           │
                           ▼
                    ┌──────────────┐
                    │     P417     │
                    └──────────────┘
                           │
                           ▼
                      ┌──────────┐
                     /   417    /
                    └──────────┘
```

**FIG. 4B**

ADI

AEI

L1

L2

L3

L1'

L2'

L3'

**FIG. 5**

EP 3 789 826 A1

input

output

Layers of CNN

**FIG. 6**

**FIG. 7A**

**FIG. 7B**

**FIG. 7C**

900

```
  ┌──────────┐      ┌──────────┐
  │   901   /      │   902   /
  └──────────┘      └──────────┘
          \         /
           \       /
          ┌───────────┐
          │   P901    │
          └───────────┘
                │
                ▼
          ┌───────────┐
          │   P903    │
          └───────────┘
                │
                ▼
          ┌───────────┐
          │   P905    │
          └───────────┘
                │
                ▼
          ┌───────────┐
          │   905    /
          └───────────┘
```

FIG. 8

**FIG. 9**

FIG. 10

**FIG. 11A**

FIG. 11B

1200

1201

P1201

P1203

1205

**FIG. 12**

**FIG. 13**

**FIG. 14**

**FIG. 15**

**FIG. 16**

FIG. 17

**FIG. 18**

**FIG. 19**

## EUROPEAN SEARCH REPORT

Europäisches
Patentamt
European
Patent Office
Office européen
des brevets

**Application Number**

EP 19 19 5527

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SEIRO MIYOSHI ET AL: "Novel prediction methodology for etched hole patterning failure", SPIE - INTERNATIONAL SOCIETY FOR OPTICAL ENGINEERING. PROCEEDINGS, vol. 8324, 9 March 2012 (2012-03-09), page 83241J, XP055673753, US ISSN: 0277-786X, DOI: 10.1117/12.916029 ISBN: 978-1-5106-3377-3 * the whole document * | 1-15 | INV. G03F7/20 H01L21/02 |
| A | WO 2019/162346 A1 (ASML NETHERLANDS BV [NL]) 29 August 2019 (2019-08-29) * abstract * * paragraphs [0087] - [0090] * | 1-15 | |

**TECHNICAL FIELDS SEARCHED (IPC)**

G03F
H01L

The present search report has been drawn up for all claims

| Place of search | Date of completion of the search | Examiner |
|---|---|---|
| Munich | 6 March 2020 | Weckesser, Jens |

**ANNEX TO THE EUROPEAN SEARCH REPORT
ON EUROPEAN PATENT APPLICATION NO.**                    EP 19 19 5527

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2020

| Patent document cited in search report | Publication date | Patent family member(s) | Publication date |
|---|---|---|---|
| WO 2019162346 A1 | 29-08-2019 | TW 201939365 A<br>WO 2019162346 A1 | 01-10-2019<br>29-08-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090157360 A

- US 7587704 B

**Non-patent literature cited in the description**

- **P. DE BISSCHOP ; E. HENDRICKX.** Stochastic effects in EUV lithography. *Proc. SPIE 10583, Extreme Ultraviolet (EUV) Lithography IX, 105831K,* 19 March 2018

- **P. DE BISSCHOP ; E. HENDRICKX.** Stochastic effects in EUV lithography. *SPIE,* 2018